# EUROPEAN PATENT APPLICATION

(11) **EP 4 658 014 A1**
(43) Date of publication of application: **03.12.2025**
(21) Application number: 25179898.9
(22) Date of filing: 30.05.2025
(51) Int. Cl.: H10B 12/00

(54) **SEMICONDUCTOR DEVICE AND METHOD FOR FABRICATING THE SAME**

(30) Priority: 30.05.2024 KR 20240070927
(71) Applicant: SK hynix Inc., Bubal-eub Icheon-si Gyeonggi-do 17336 (KR)
(72) Inventor: KIM, Gil Seop, 17336 Icheon-si, Gyeonggi-do (KR); JIN, Hyun Woo, 17336 Icheon-si, Gyeonggi-do (KR)
(74) Representative: Isarpatent

(57) **Abstract**

The present disclosure relates to a semiconductor device and a method for fabricating the semiconductor device. The method for fabricating a semiconductor device includes forming a vertical stack in which dielectric layers are alternately stacked with horizontal layer patterns, over a lower structure; forming cell isolation layers that contact side surfaces of the horizontal layer patterns and vertically extend in the vertical stack; forming a sacrificial structure that covers upper surfaces and lower surfaces of the horizontal layer patterns in the vertical stack; forming a hole-shape opening that vertically extends, by etching the sacrificial structure and the cell isolation layers; forming a double pocket layer on a sidewall of the hole-shape opening; forming storage openings, by recessing the horizontal layer patterns and the cell isolation layers using the double pocket layer as a barrier; and forming a data storage element in each of the storage openings.

## Description

### BACKGROUND

### 1. Field

Various embodiments of the present disclosure relate to a semiconductor device, and more particularly, to a semiconductor device including three-dimensional (3D) memory cells, and a method for fabricating the semiconductor device.

### 2. Description of the Related Art

Recently, in order to cope with the trend of large capacity and miniaturization of memory devices, technology for providing a three-dimensional (3D) memory device in which a plurality of memory cells are stacked is being proposed.

### SUMMARY

Embodiments of the present disclosure are directed to a semiconductor device including highly integrated memory cells, and a method for fabricating the semiconductor device.

In accordance with an embodiment of the present disclosure, a method for fabricating a semiconductor device may include forming a vertical stack in which dielectric layers are alternately stacked with horizontal layer patterns, over a lower structure; forming cell isolation layers that contact side surfaces of the horizontal layer patterns and vertically extend in the vertical stack; forming a sacrificial structure that covers upper surfaces and lower surfaces of the horizontal layer patterns in the vertical stack; forming a hole-shape opening that vertically extends, by etching the sacrificial structure and the cell isolation layers; forming a double pocket layer on a sidewall of the hole-shape opening; forming storage openings, by recessing the horizontal layer patterns and the cell isolation layers using the double pocket layer as a barrier; and forming a data storage element in each of the storage openings.
In accordance with an embodiment of the present disclosure, a method for fabricating a semiconductor device may include forming a vertical stack in which dielectric layers are alternately stacked with horizontal layer patterns, over a lower structure; forming cell isolation layers that contact side surfaces of the horizontal layer patterns and vertically extend in the vertical stack; forming a sacrificial structure that covers upper surfaces, lower surfaces, and edges of the horizontal layer patterns in the vertical stack; etching the sacrificial structure and forming a capping layer covering the upper surfaces and lower surfaces of the horizontal layer patterns and a hole-shape opening exposing the dielectric layers, the horizontal layer patterns, and the cell isolation layers; forming a double pocket layer that covers the dielectric layers and the capping layer and exposes the edges of the horizontal layer patterns; forming storage openings by recessing the horizontal layer patterns and the cell isolation layers using the double pocket layer as a barrier; and forming a data storage element in each of the storage openings.E each of the horizontal layer patterns includes monocrystalline silicon, an oxide semiconductor material, or a two-dimensional material.

In accordance with an embodiment of the present disclosure, a semiconductor device may include a lower structure; a vertical stack including horizontal layers and horizontal conductive lines, which are stacked in a vertical direction from the lower structure; a cell isolation layer supporting side surfaces of the horizontal layers and side surfaces of the horizontal conductive lines and including a stopper layer and a cell isolation liner that surrounds the stopper layer and contacts the horizontal layers and the horizontal conductive lines; a vertical conductive line coupled in common to first edges of the horizontal layers and vertically extending in a stack direction of the horizontal conductive lines; and data storage elements coupled to second edges of the horizontal layers.
In some embodiments, Each of the data storage elements includes: a first electrode coupled to the second edge of each of the horizontal layers; a dielectric layer on the first electrode; and a second electrode on the dielectric layer, wherein the dielectric layer extends to penetrate the cell isolation liner and contact the stopper layer of the cell isolation layer.

In some embodiments, the semiconductor device may further include an inner-type contact node formed between a second edge of the horizontal layer and the first electrode.

In some embodiments, each of the horizontal layers includes a cross-shape channel having a cross-shape cross-section, and each of the horizontal conductive lines includes a cross-shape channel overlapping portion that overlaps with the cross-shape channel.

### BRIEF DESCRIPTION OF THE DRAWINGS

FIG. 1A is a schematic perspective view illustrating a memory cell in accordance with an embodiment of the present disclosure.
FIG. 1B is a schematic cross-sectional view of the memory cell of FIG. 1A.
FIG. 1C is a plan view illustrating a switching element shown in FIG. 1A.
FIG. 1D is a schematic cross-sectional view illustrating a memory cell in accordance with an embodiment of the present disclosure.
FIG. 1E is a schematic perspective view illustrating a semiconductor device in accordance with an embodiment of the present disclosure.
FIG. 2A is a schematic plan view illustrating a semiconductor device in accordance with an embodiment of the present disclosure.
FIG. 2B is a cross-sectional view illustrating the semiconductor device taken along line A-A' shown in FIG. 2A.
FIGS. 3A to 25B illustrate various views of a semiconductor device formed utilizing a method for fabricating the semiconductor device in accordance with an embodiment of the present disclosure.
FIG. 26 is a plan view illustrating a semiconductor device formed utilizing a method for forming second hole-shape vertical openings in accordance with an embodiment of the present disclosure.

### DETAILED DESCRIPTION

Various embodiments of the present disclosure described herein may be described with reference to cross-sectional views, plan views and block diagrams, which are ideal schematic views of a semiconductor device. It is noted that the structures of the drawings may be modified by fabricating techniques and/or tolerances. The present disclosure is not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements and are not intended to limit the scope of the embodiments of the present disclosure.

Embodiments described below relate to three-dimensional (3D) memory cells with memory cells vertically stacked for increasing the memory cell density and reducing parasitic capacitance.

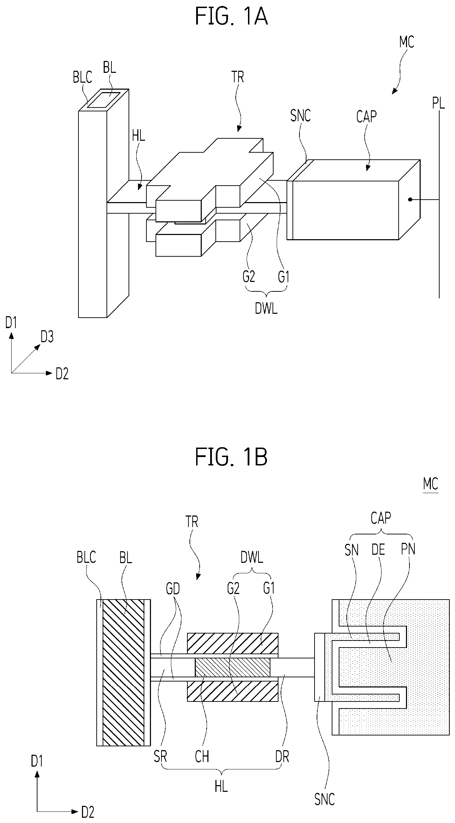

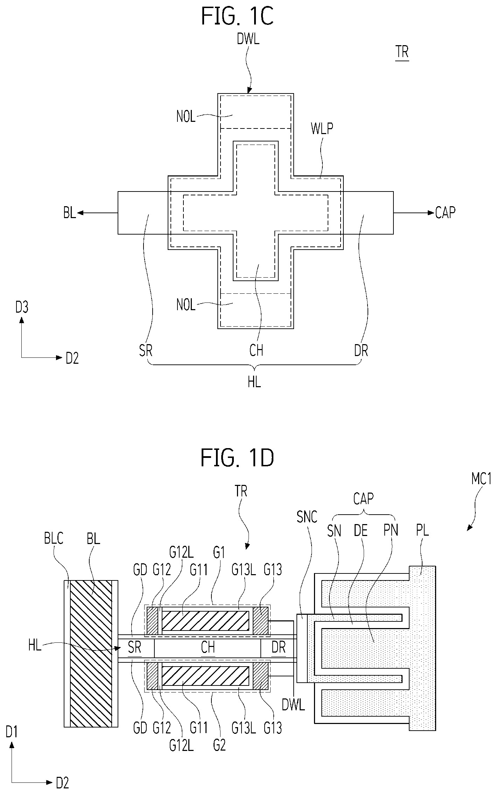

FIG. 1A is a schematic perspective view illustrating a memory cell MC in accordance with an embodiment of the present disclosure. FIG. 1B is a schematic cross-sectional view of the memory cell MC shown in FIG. 1A. FIG. 1C is a plan view illustrating a switching element shown in FIG. 1A.

Referring to FIGS. 1A to 1C, the memory cell MC may include first conductive line BL, switching element TR, and data storage element CAP.

The first conductive line BL may be vertically oriented in a first direction D1. The first conductive line BL may include a bit line. The first conductive line BL may also be referred to as a vertical conductive line, a vertically-oriented bit line, a vertically-extending bit line, or a pillar-shape bit line. The first conductive line BL may include a conductive material such as, for example, a silicon-based material, a metal, a metal-based material, or a combination thereof. The silicon-based material may for example include polysilicon. The metal may be tungsten. The metal-based material may be metal nitride, metal silicide, or a combination thereof. In an embodiment, the first conductive line BL may include polysilicon, titanium nitride, tungsten, or a combination thereof. For example, the first conductive line BL may include a stack (TiN/W) of titanium nitride and tungsten.

The switching element TR may control the voltage (or current) supply to the data storage element CAP during a data write operation and a data read operation performed onto the data storage element CAP. The switching element TR may include a horizontal layer HL, an inter-level dielectric layer GD, and a second conductive line DWL. The second conductive line DWL may include a horizontal conductive line or a horizontal word line, and the horizontal layer HL may include an active layer or a channel body layer. The switching element TR may include a transistor, and in this case, the second conductive line DWL may function as a gate electrode. The switching element TR may be referred to as an access element or a selection element. The second conductive line DWL may be referred to as a horizontal gate electrode or a horizontal word line. The switching element TR may also be referred to as a Nano-sheet channel transistor.

The horizontal layer HL may extend in a second direction D2 that intersects with the first direction D1. The second conductive line DWL may extend in a third direction D3 that intersects with the first direction D1 and the second direction D2. The first direction D1 may be a vertical direction, the second direction D2 may be a first horizontal direction, and the third direction D3 may be a second horizontal direction. The horizontal layer HL may extend in the first horizontal direction, i.e., the second direction D2, and the second conductive line DWL may extend in the second horizontal direction, i.e., the third direction D3.

The horizontal layer HL may be horizontally oriented in the second direction D2 from the first conductive line BL. The second conductive line DWL may have a double structure. For example, the second conductive line DWL may include an upper (or a top) horizontal line G1 and a lower (or a bottom) horizontal line G2 facing each other with the horizontal layer HL interposed therebetween. The inter-level dielectric layer GD may be formed on upper and lower surfaces (also referred to as top and bottom surfaces) of the horizontal layer HL. The upper horizontal line G1 may be disposed in the upper portion of the horizontal layer HL, and the lower horizontal line G2 may be disposed in the lower portion of the horizontal layer HL. The second conductive line DWL may include a pair of the upper horizontal line G1 and the lower horizontal line G2. In operation, in the second conductive line DWL, the same driving voltage may be applied to the upper horizontal line G1 and the lower horizontal line G2. For example, the upper horizontal line G1 and the lower horizontal line G2 may form a pair to be coupled to one memory cell MC. According to another embodiment of the present invention disclosure, different driving voltages may be applied to the upper horizontal line G1 and the lower horizontal line G2. In this case, one horizontal line among the upper horizontal line G1 and the lower horizontal line G2 may function as a back gate or a shield gate.

Referring to FIG. 1C, each of the upper horizontal line G1 and the lower horizontal line G2 may have a width in the second direction D2, for example, the width of an overlapping portion that overlaps with the horizontal layer HL, which is greater than the width of a non-overlapping portion that does not overlap with the horizontal layer HL. Due to the difference in the widths, the second conductive line DWL may have a notch-shape sidewall. The second conductive line DWL may include a channel overlapping portion WLP and a channel non-overlapping portion NOL. The channel overlapping portion WLP may refer to a portion that overlaps with a channel CH of the horizontal layer HL. The channel non-overlapping portion NOL may refer to a portion that does not overlap with the horizontal layer HL. The channel overlapping portion WLP may have a cross shape or a rhombus shape.

From the perspective of a top view, the horizontal layer HL may have a cross shape or a rhombus shape. According to another embodiment of the present disclosure, the side surfaces of the horizontal layer HL may have a bent shape or a rounded shape.

The horizontal layer HL may include a semiconductor material, such as, for example, polysilicon, monocrystalline silicon, germanium, or silicon-germanium. According to another embodiment of the present disclosure, the horizontal layer HL may include an oxide semiconductor material, such as for example, Indium Gallium Zinc Oxide (IGZO). According to another embodiment of the present disclosure, the horizontal layer HL may include a two-dimensional material. The two-dimensional material may include, for example, at least one of molybdenum disulfide (MoS₂), molybdenum diselenide (MoSe₂), tungsten disulfide (WS₂), and tungsten diselenide (WSe₂), but the embodiments of the present disclosure are not limited thereto. According to another embodiment of the present disclosure, the horizontal layer HL may include a conductive metal oxide.

The upper and lower surfaces of the horizontal layer HL may be flat. The upper and lower surfaces of the horizontal layer HL may be parallel to each other in the second direction D2.

The horizontal layer HL may include the channel CH, a first doped region SR between the channel CH and the first conductive line BL, and a second doped region DR between the channel CH and the data storage element CAP. When the horizontal layer HL is formed of an oxide semiconductor material or a two-dimensional material, the channel CH may be formed of an oxide semiconductor material or a two-dimensional material, then the first and second doped regions SR and DR may be omitted. The horizontal layer HL may be referred to as an active layer, a thin-body, or a channel body. The channel CH and the channel overlapping portion WLP of the second conductive line DWL may overlap with each other. The channel CH may have a cross shape or a rhombus shape. The size of the channel overlapping portion WLP of the second conductive line DWL may be greater than that of the channel CH. The channel overlapping portion WLP of the second conductive line DWL may fully overlap with the channel CH.

The first doped region SR and the second doped region DR may be doped with impurities of the same conductivity type. The first doped region SR and the second doped region DR may be doped with an N-type conductive impurity or a P-type conductive impurity. The first doped region SR and the second doped region DR may include at least one impurity selected from among arsenic (As), phosphorus (P), boron (B), indium (In), and a combination thereof. The first doped region SR may be coupled to the first conductive line BL, and the second doped region DR may be coupled to the data storage element CAP. The first and second doped regions SR and DR may be referred to as first and second source/drain regions. A first side surface of the horizontal layer HL may be an end portion of the first doped region SR, and a second side surface of the horizontal layer HL may be an end portion of the second doped region DR. The first side surface of the horizontal layer HL may be coupled to the first conductive line BL, and the second side surface of the horizontal layer HL may be coupled to the data storage element CAP. From the perspective of a top view, the first and second side surfaces of the horizontal layer HL may be symmetrical or asymmetrical with respect to each other in the second direction D2.

The inter-level dielectric layer GD may be disposed between the horizontal layer HL and the second conductive line DWL. The inter-level dielectric layer GD may be referred to as a gate dielectric layer. The inter-level dielectric layer GD may also be referred to as a horizontal layer side dielectric layer. The inter-level dielectric layer GD may include silicon oxide, silicon nitride, metal oxide, metal oxynitride, metal silicate, a high-k material, a ferroelectric material, an anti-ferroelectric material, or a combination thereof. The inter-level dielectric layer GD may include SiO₂, Si₃N₄, HfO₂, Al₂O₃, ZrO₂, AlON, HfON, HfSiO, HfSiON, HfZrO, or a combination thereof. The inter-level dielectric layer GD may be formed by a thermal oxidation process of a semiconductor material.

The second conductive line DWL may include a metal, a metal-based material, a semiconductor material, or a combination thereof. The second conductive line DWL may include titanium nitride, tungsten, polysilicon, or a combination thereof. For example, the second conductive line DWL may include a TiN/W stack in which titanium nitride and tungsten are sequentially stacked. The second conductive line DWL may include an N-type work function material or a P-type work function material. The N-type work function material may have a low work function of approximately 4.5 eV or lower, and the P-type work function material may have a high work function of approximately 4.5 eV or higher. The second conductive line DWL may include a stack of a low work function material and a high work function material.

The data storage element CAP may include a memory element, such as a capacitor. The data storage element CAP may be horizontally disposed in the second direction D2 from the switching element TR. The data storage element CAP may include a first electrode SN horizontally extending from the horizontal layer HL in the second direction D2. The data storage element CAP may further include a second electrode PN on the first electrode SN, and a dielectric layer DE between the first electrode SN and the second electrode PN. The first electrode SN, the dielectric layer DE, and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1, and the horizontal outer surfaces of the first electrode SN may horizontally extend in the second direction D2 or the third direction D3. The inner space of the first electrode SN may be a three-dimensional space. The dielectric layer DE may conformally cover the inner and outer surfaces of the first electrode SN. The second electrode PN may be disposed in the inner space of the first electrode SN on the dielectric layer DE. Some of the outer surfaces of the first electrode SN may be electrically coupled to the second doped region DR of the horizontal layer HL. The second electrode PN of the data storage element CAP may be coupled to a common plate PL.

The data storage element CAP may have a three-dimensional structure. The first electrode SN may have a three-dimensional structure, and the first electrode SN having the three-dimensional structure may have a horizontal three-dimensional structure that is oriented in the second direction D2. As an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region DR of the horizontal layer HL. The dielectric layer DE and the second electrode PN may be disposed on the cylindrical inner surfaces of the first electrode SN. When the dielectric layer DE and the second electrode PN partially cover the cylindrical outer surfaces of the first electrode SN, the first electrode SN may be referred to as a semi-cylindrical shape.

According to another embodiment of the present disclosure, the first electrode SN may have a pillar shape or a pylinder shape. The pylinder shape may refer to a structure in which a pillar shape and a cylindrical shape are merged.

The first electrode SN and the second electrode PN may include metal, noble metal, metal nitride, conductive metal oxide, conductive noble metal oxide, metal carbide, metal silicide, or a combination thereof. For example, the first electrode SN and the second electrode PN may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/ titanium nitride (TiSiN/TiN) stack, a titanium nitride/titanium silicon nitride (TiN/TiSiN) stack, or a combination thereof. The second electrode PN may also include a combination of a metal-based material and a silicon-based material. For example, the second electrode PN may be a stack (TiN/SiGe/WN) of titanium nitride/silicon germanium/tungsten nitride. In the titanium nitride/silicon germanium/tungsten nitride (TiN/SiGe/WN) stack, silicon germanium may be a gap-fill material that fills the inside of the first electrode SN, and titanium nitride (TiN) may serve as the second electrode PN of the data storage element CAP, and tungsten nitride may be a low-resistance material.

The dielectric layer DE may be referred to as a capacitor dielectric layer or a memory layer. The dielectric layer DE may include silicon oxide, silicon nitride, a high-k material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅) or strontium titanium oxide (SrTiO₃). According to another embodiment of the present disclosure, the dielectric layer DE may be formed of a composite layer including two or more layers of the above-described high-k material.

The dielectric layer DE may be formed of zirconium (Zr)-based oxide (Zr-based oxide). The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃), and zirconium oxide (ZrO₂) are sequentially stacked. Each of the ZA stack and the ZAZ stack may be referred to as a zirconium oxide-based layer (ZrO₂-based layer). According to another embodiment of the present disclosure, the dielectric layer DE may be formed of hafnium-based oxide (Hf-based oxide). The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃), and hafnium oxide (HfO₂) are sequentially stacked. Each of the HA stack and the HAH stack may be referred to as a hafnium oxide-based layer (HfO₂-based layer). In the ZA stack, ZAZ stack, HA stack, and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include silicon oxide (SiO₂) as a high band gap material other than aluminum oxide (Al₂O₃). Since the dielectric layer DE includes a high band gap material, leakage current may be suppressed. The high band gap material may be thinner than the high-k material. According to another embodiment of the present disclosure, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH(HfO₂/ZrO₂/Al₂O₃/ZrO₂/HfO₂) stack, a ZHZAZHZ(ZrO₂/HfO₂/ZrO₂/Al₂O₃/ZrO₂/HfO₂/ZrO₂) stack, a HZHZ(HfO₂/ZrO₂/HfO₂/ZrO₂) stack, or AHZAZHA(Al₂O₃/HfO₂/ZrO₂/Al₂O₃/ZrO₂/HfO₂/Al₂O₃) stack. In the above-described stack structures, aluminum oxide (Al₂O₃) may be thinner than zirconium oxide (ZrO₂) and hafnium oxide (HfO₂).

According to another embodiment of the present disclosure, the dielectric layer DE may include a high-k material and a high band gap material, and the dielectric layer DE may have a laminated structure in which a plurality of high-k materials and a plurality of high band gap materials are stacked, or an intermixed structure in which a high-k material and a high band gap material are intermixed.

According to another embodiment of the present disclosure, the dielectric layer DE may include a ferroelectric material, an anti-ferroelectric material, or a combination thereof. For example, the dielectric layer DE may include HfZrO.

According to another embodiment of the present disclosure, the dielectric layer DE may include a combination of a high-k material and a ferroelectric material, a combination of a high-k material and an anti-ferroelectric material, or a combination of a high-k material or a ferroelectric material and an anti-ferroelectric material.

According to another embodiment of the present disclosure, the dielectric layer DE may include a perovskite material. For example, the perovskite material may include ABO-based oxide, wherein "A" may be a first metal, "B" may be a second metal, and "O" may be oxygen. In the ABO-based oxide, "A" may include Be, Mg, Ca, Sr, Ba, or La, and "B" may include Ti, V, Zr, Hf, Ru, Mo, Sc, Cr, Mn, Fe, Co, Ni, Cu, or Zn.

According to another embodiment of the present disclosure, an interface control layer may be further formed between the first electrode SN and the dielectric layer DE to improve leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode PN and the dielectric layer DE.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

For example, the memory cell MC may include a thyristor, and the first conductive line BL may be a cathode line, and the data storage element CAP may be replaced with an anode line. Accordingly, the horizontal layer HL may include four semiconductor layers that are stacked in the second direction D2. The thyristor may include a first diode and a second diode that are coupled in series. When a forward bias having the same voltage is applied to the thyristor, the thyristor may have a high conductance state in which a large amount of current flows, or a low conductance state in which a small amount of current flows or no current flows. The memory cell MC according to an embodiment of the present disclosure may have a "1" state and a "0" state by using the high conductance state and the low conductance state of the thyristor, respectively.

Referring back to FIGS. 1A and 1B, the memory cell MC may further include a first contact node BLC surrounding the outer wall of the first conductive line BL and a second contact node SNC disposed between the horizontal layer HL and the first electrode SN. The first contact node BLC may include a metal, a metal-based material or a semiconductor material. The second contact node SNC may include a metal, a metal-based material or a semiconductor material. For example, the first and second contact nodes BLC and SNC may each include titanium, titanium nitride, tungsten, or a combination thereof. In addition, the first and second contact nodes BLC and SNC may each include doped polysilicon, and the first doped region SR and the second doped region DR may include impurities diffused from the first contact node BLC and the second contact node SNC, respectively. The first contact node BLC may be an outer-type contact node, and the second contact node SNC may be an inner-type contact node.

FIG. 1D is a schematic cross-sectional view illustrating a memory cell MC1 in accordance with an embodiment of the present disclosure. The memory cell MC1 shown in FIG. 1D may be similar to the memory cell MC shown in FIGS. 1A to 1C. Hereinafter, detailed descriptions of the constituent elements also appearing in FIG. 1D are omitted.

The memory cell MC1 may include a first conductive line BL, a switching element TR, and a data storage element CAP. The switching element TR may include a horizontal layer HL, an inter-level dielectric layer GD, and a second conductive line DWL. The horizontal layer HL may include a first doped region SR, a second doped region DR, and a channel CH disposed between the first and second doped regions SR and DR. The data storage element CAP may include a first electrode SN, a second electrode PN, and a dielectric layer DE disposed between the first and second electrodes SN and PN.

The memory cell MC1 may further include a first contact node BLC disposed between the first conductive line BL and the horizontal layer HL and a second contact node SNC disposed between the horizontal layer HL and the data storage element CAP. The first and second contact nodes BLC and SNC may each include doped polysilicon. The first doped region SR and the second doped region DR may include impurities diffused from the first contact node BLC and the second contact node SNC, respectively.

The second conductive line DWL may include an upper horizontal line G1 and a lower horizontal line G2. Each of the upper horizontal line G1 and the lower horizontal line G2 may include a first work function electrode G11, a second work function electrode G12, and a third work function electrode G13. The first work function electrode G11, the second work function electrode G12, and the third work function electrode G13 may be horizontally disposed in a second direction D2. The first work function electrode G11, the second work function electrode G12, and the third work function electrode G13 may be in direct contact with one another. The second work function electrode G12 may be adjacent to the first conductive line BL, and the third work function electrode G13 may be adjacent to the data storage element CAP. The horizontal layer HL may have a smaller thickness than the first, second, and third work function electrodes G11, G12, and G13.

The first work function electrode G11, the second work function electrode G12, and the third work function electrode G13 are formed of different work function materials. The first work function electrode G11 may have a higher work function than the second and third work function electrodes G12 and G13. The first work function electrode G11 may include a high work function material. The first work function electrode G11 may have a work function higher than a mid-gap work function of silicon. The second and third work function electrodes G12 and G13 may each include a low work function material. The second and third work function electrodes G12 and G13 may each have a work function lower than the mid-gap work function of silicon. Specifically, the high work function material may have a work function higher than 4.5 eV, and the low work function material may have a work function lower than 4.5 eV. The first work function electrode G11 may include a metal, or a metal-based material, and the second and third work function electrodes G12 and G13 may each include a semiconductor material.

The second and third work function electrodes G12 and G13 may each include N-type dopant doped polysilicon. The first work function electrode G11 may include metal, metal nitride, or a combination thereof. The first work function electrode G11 may include tungsten, titanium nitride, or a combination thereof. A barrier material may be further formed between the second and third work function electrodes G12 and G13 and the first work function electrode G11.

According to an embodiment of the present disclosure, in each of the upper and lower horizontal lines G1 and G2 of the second conductive line DWL, the second work function electrode G12, the first work function electrode G11 and the third work function electrode G13 may be horizontally disposed in this order in the second direction D2. The first work function electrode G11 may include metal, and the second work function electrode G12 and the third work function electrode G13 may each include polysilicon.

Each of the upper and lower horizontal lines G1 and G2 of the second conductive line DWL may have a poly Si-metal-poly Si (PMP) structure horizontally disposed in the second direction D2. In the PMP structure, the first work function electrode G11 may be a metal-based material, and the second and third work function electrodes G12 and G13 may each be N-type dopant doped polysilicon. The N-type dopant may include phosphorus or arsenic.

A first barrier layer G12L may be disposed between the first work function electrode G11 and the second work function electrode G12. A second barrier layer G13L may be disposed between the first work function electrode G11 and the third work function electrode G13. The first and second barrier layers G12L and G13L may each include titanium nitride, tantalum nitride, tungsten nitride, or molybdenum nitride. The second barrier layer G13L may cover an upper surface, a lower surface and one side surface of the first work function electrode G11.

The first work function electrode G11 may have a larger volume than the second and third work function electrodes G12 and G13, and thus the second conductive line DWL may have a low resistance. The first work function electrodes G11 of the upper and lower horizontal lines G1 and G2 may vertically overlap in a first direction D1 with the horizontal layer HL interposed therebetween. The second and third work function electrodes G12 and G13 of the upper and lower horizontal lines G1 and G2 may vertically overlap in the first direction D1 with the horizontal layer HL interposed therebetween. An overlapping area between the first work function electrode G11 and the horizontal layer HL may be greater than an overlapping area between the second and third work function electrodes G12 and G13 and the horizontal layer HL. The first work function electrode G11 may extend in a third direction D3. The second and third work function electrodes G12 and G13 may each have an independent structure of overlapping with the horizontal layer HL. For example, the first work function electrode G11 may include a channel overlapping portion WLP and a channel non-overlapping portion NOL, and the second and third work function electrodes G12 and G13 may be a part of the channel overlapping portion WLP. The second and third work function electrodes G12 and G13 and the first work function electrode G11 may directly contact each other.

As described above, each of the upper and lower horizontal lines G1 and G2 may have a triple work function electrode structure including the first, second, and third work function electrodes G11, G12 and G13. The second conductive line DWL may have a pair of the first work function electrodes G11, a pair of the second work function electrodes G12, and a pair of the third work function electrodes G13, which extend in the third direction D3 crossing the horizontal layer HL, with the horizontal layer HL interposed therebetween. The first work function electrodes G11, the second work function electrodes G12 and the third work function electrodes G13 may vertically overlap with the channel CH.

The second conductive lines DWL may include a channel overlapping portion WLP and a channel non-overlapping portion NOL as illustrated in FIG. 1C. The channel overlapping portion WLP may have a cross shape or a rhombus shape. The channel overlapping portion WLP may fully overlap with the channel CH. The second conductive line DWL extending in the third direction D3 may have notch-shape sidewalls by the channel overlapping portion WLP and the channel non-overlapping portion NOL. From the perspective of a top view, the notch-shape sidewalls may be provided by protruding portions by the channel overlapping portions WLP and recessed portions by the channel non-overlapping portions NOL. The channel overlapping portion WLP may include the first work function electrodes G11, the second work function electrodes G12, and the third work function electrodes G13, and the first work function electrodes G11, the second work function electrodes G12, and the third work function electrodes G13 may vertically overlap with the channel CH.

In the second direction D2, the first work function electrode G11 having a high work function is disposed at the center of the second conductive line DWL, and the second and third work function electrodes G12 and G13 each having a low work function are disposed at both ends of the second conductive line DWL. Accordingly, leakage current such as gate induced drain leakage (GIDL) may be alleviated.

As the first work function electrode G11 having a high work function is disposed at the center of the second conductive line DWL, a threshold voltage of the switching element TR may increase. Since the second work function electrode G12 of the second conductive line DWL has a low work function, a low electric field may be formed between the first conductive line BL and the second conductive line DWL. Since the third work function electrode G13 of the second conductive line DWL has a low work function, a low electric field may be formed between the data storage element CAP and the second conductive line DWL.

As described above, the memory cell MC1 may include the second conductive line DWL having a triple work function electrode structure. Each of the upper and lower horizontal lines G1 and G2 of the second conductive line DWL may include the first work function electrode G11, the second work function electrode G12, and the third work function electrode G13. The first work function electrode G11 may overlap with the channel CH, the second work function electrode G12 may be adjacent to the first conductive line BL and the first doped region SR, and the third work function electrode G13 may be adjacent to the data storage element CAP and the second doped region DR. Due to a low work function of the second work function electrode G12, a low electric field is formed between the second conductive line DWL and the first conductive line BL, thereby making it possible to reduce leakage current. Due to a low work function of the third work function electrode G13, a low electric field is formed between the second conductive line DWL and the data storage element CAP, thereby making it possible to reduce leakage current. Due to a high work function of the first work function electrode G11, a threshold voltage of the switching element TR may increase. In addition, due to a high work function of the first work function electrode G11, it is possible to reduce the height of the memory cell MC1, which is advantageous in terms of integration.

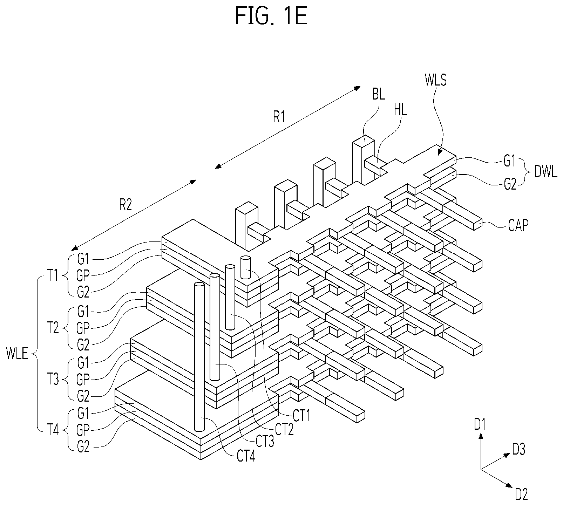

FIG. 1E is a schematic perspective view illustrating a semiconductor device in accordance with an embodiment of the present disclosure. FIG. 1E illustrates a three-dimensional array of the memory cell shown in FIGS. 1A to 1D. Hereinafter, for detailed descriptions of the constituent elements also appearing in FIG. 1E, reference is made to FIGS. 1A to 1D also.

Referring to FIGS. 1A to 1E, the semiconductor device may include a plurality of vertical stacks WLS extending lengthwise in a third direction D3. The vertical stacks WLS may be disposed in a first region R1. Each of the vertical stacks WLS may include a column array and a row array of the memory cells MC.

The vertical stack WLS may refer to a stack of a plurality of second conductive lines DWL stacked in a first direction D1. The second conductive lines DWL of the vertical stack WLS may have an integral structure of extending from first region R1 to second region R2.

The vertical stack WLS may include a pad portion WLE. The pad portion WLE of the vertical stack WLS may be disposed in the second region R2. The pad portion WLE may have a stepped structure including a stack of the second conductive lines DWL. Contact structures CT1 to CT4 may be coupled to the pad portion WLE. The pad portion WLE may be referred to as a contact portion, an edge portion, or a connection portion.

The second conductive lines DWL may include a plurality of levels T1, T2, T3, and T4. For example, the first level T1 may refer to the second conductive line DWL at the highest level, and the fourth level T4 may refer to the second conductive line DWL at the lowest level. The second level T2 may be lower than the first level T1, and the third level T3 may be lower than the second level T2. The fourth level T4 may be lower than the third level T3. Each level T1 to T4 may be referred to as a tier.

The fourth level T4, the third level T3, the second level T2 and the first level T1 may be sequentially stacked in the first direction D1.

In the vertical stack WLS and the pad portion WLE, the second conductive line DWL of each level T1 to T4 may include a pair of the upper and lower horizontal lines G1 and G2.

In the pad portion WLE, each of the levels T1 to T4 may further include pads GP. The pads GP may be disposed between the upper horizontal line G1 and the lower horizontal line G2. Each pad GP may be electrically coupled to the upper and lower horizontal lines G1 and G2.

The lateral lengths of the pads GP in the third direction D3 may be different from one another. The pads GP disposed in the second region R2 and the horizontal layers HL disposed in the first region R1 may be spaced apart from each other. The pads GP may not be disposed in the first region R1.

The pads GP, the upper horizontal lines G1 and the lower horizontal lines G2 may include the same material. The pads GP, the upper horizontal lines G1 and the lower horizontal lines G2 may include a metal, or a metal-based material. For example, the pads GP, the upper horizontal lines G1 and the lower horizontal lines G2 may include titanium nitride, tungsten, or a combination thereof.

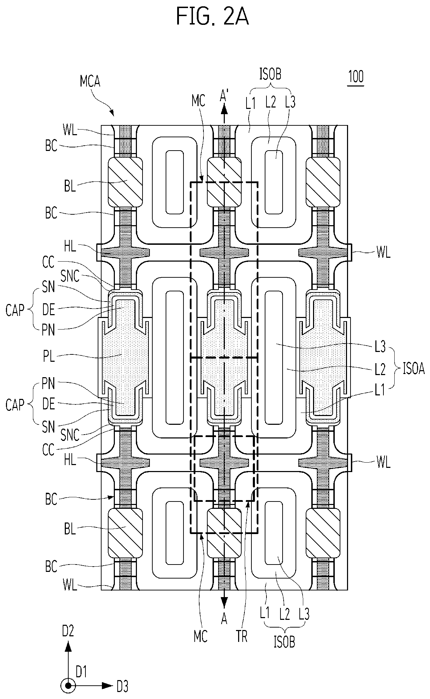

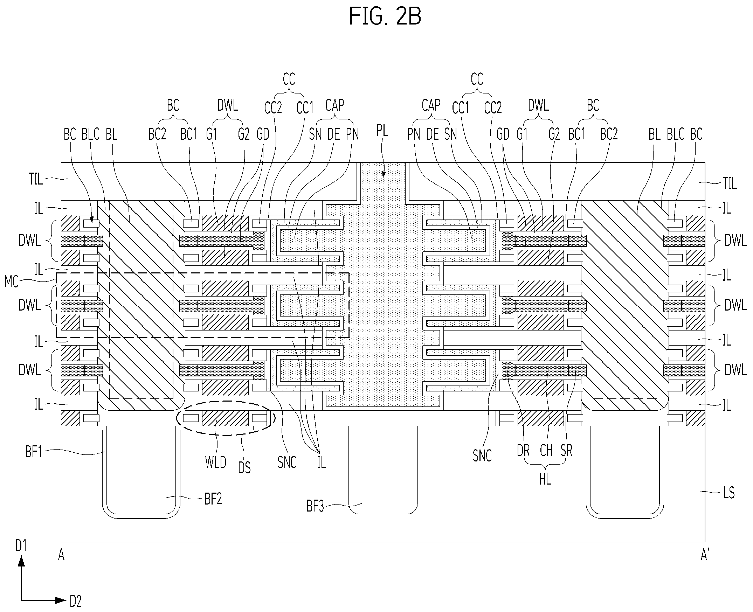

FIG. 2A is a schematic plan view illustrating a semiconductor device 100 in accordance with an embodiment of the present disclosure. FIG. 2B is a cross-sectional view illustrating the semiconductor device 100 taken along line A-A' shown in FIG. 2A.

Referring to FIGS. 2A and 2B, the semiconductor device 100 may include a memory cell array MCA. The memory cell array MCA may include a plurality of memory cells MC. As for each memory cell MC, FIGS. 1A to 1C may be referred to. Each memory cell MC may include a first conductive line BL, a switching element TR, and a data storage element CAP.

The memory cell array MCA may include a three-dimensional array of the memory cells MC. The three-dimensional array of the memory cells MC may include a column array of the memory cells MC and a row array of the memory cells MC. The column array of the memory cells MC may include a plurality of memory cells MC that are stacked in a first direction D1, and the row array of the memory cells MC may include a plurality of memory cells MC that are horizontally disposed in a second direction D2 and a third direction D3. The memory cell array MCA may include sub-memory cell arrays disposed adjacent to one another in the second direction D2. Each of the sub-memory cell arrays may have a mirror-type structure in which two memory cells MC share the first conductive line BL. According to another embodiment of the present disclosure, the semiconductor device 100 may further include sub-memory cell arrays each having a mirror-type structure in which two memory cells MC share a second electrode PN of the data storage element CAP. The memory cell array MCA may include a plurality of sub-memory cell arrays in which the memory cells MC are vertically stacked in the first direction D1. The memory cell array MCA may include a plurality of sub-memory cell arrays that are horizontally disposed in the third direction D3.

According to another embodiment of the present disclosure, the memory cell array MCA may include a plurality of sub-memory cell arrays disposed in the second direction D2. For example, the data storage element CAP, the switching element TR, the first conductive line BL, and the switching element TR may be sequentially and alternately disposed in the second direction D2.

Inter-cell dielectric layers IL may be disposed between the memory cells MC that are stacked in the first direction D1. The inter-cell dielectric layers IL may each include silicon oxide. The inter-cell dielectric layers IL may be referred to as horizontal inter-cell dielectric layers. A top dielectric layer TIL may be disposed over the uppermost level-cell dielectric layer IL.

Cell isolation layers ISOA and ISOB may be disposed between neighboring memory cells MC in the third direction D3. The cell isolation layers ISOA and ISOB may be referred to as vertical inter-cell dielectric layers. The cell isolation layers ISOA and ISOB may each include silicon oxide, silicon carbon oxide (SiCO), silicon nitride, or a combination thereof. The cell isolation layers ISOA and ISOB may include first cell isolation layers ISOA and second cell isolation layers ISOB. The first and second cell isolation layers ISOA and ISOB may vertically extend in the first direction D1. The first and second cell isolation layers ISOA and ISOB may each have a pillar structure vertically extending in the first direction D1. The first and second cell isolation layers ISOA and ISOB may be alternately and repeatedly disposed in the second direction D2. The first cell isolation layers ISOA may be disposed between the data storage elements CAP in the third direction D3. The second cell isolation layers ISOB may be disposed between the first conductive lines BL in the third direction D3. Second conductive lines DWL may be disposed between the first cell isolation layers ISOA and the second cell isolation layers ISOB in the second direction D2. Each of the first cell isolation layers ISOA and the second cell isolation layers ISOB may include a stack of a cell isolation liner layer L1, a stopper layer L2, and a cell isolation gap-fill layer L3. The cell isolation liner layer L1 may include silicon oxide, and the cell isolation gap-fill layer L3 may include silicon oxide or silicon carbon oxide. The stopper layer L2 may have an etch selectivity with respect to the cell isolation liner layer L1 and the cell isolation gap-fill layer L3. For example, the stopper layer L2 may include silicon nitride. The cell isolation gap-fill layer L3 may include an air gap, silicon oxide with an air gap embedded, or silicon carbon oxide with an air gap embedded.

The memory cell array MCA may be disposed over a lower structure LS.

The memory cell array MCA may include a plurality of second conductive lines DWL that are vertically stacked in the first direction D1. The memory cell array MCA may include a plurality of horizontal layers HL that are vertically stacked in the first direction D1. The memory cell array MCA may include a plurality of data storage elements CAP that are vertically stacked in the first direction D1. The memory cell array MCA may include a plurality of first conductive lines BL that are spaced apart from one another in the third direction D3.

Each of the second conductive lines DWL may include a channel overlapping portion WLP and a channel non-overlapping portion NOL as illustrated in FIG. 1C. The channel overlapping portion WLP may have a cross shape or a rhombus shape. The channel overlapping portion WLP may fully overlap with a channel CH. The second conductive line DWL extending in the third direction D3 may include a plurality of channel overlapping portions WLP. As the channel overlapping portions WLP and the channel non-overlapping portions NOL are alternately repeated in the third direction D3, the second conductive line DWL may have a notch-shape sidewall.

A dummy second conductive line WLD may be disposed between the lowermost second conductive line DWL among the plurality of second conductive lines DWL and the lower structure LS. A first passivation layer BF1 may be disposed between the dummy second conductive line WLD and the lower structure LS. A second passivation layer BF2 may be disposed between the first conductive line BL and the first passivation layer BF1. Third passivation layers BF3 may be disposed between the data storage element CAP and the lower structure LS. The first to third passivation layers BF1, BF2 and BF3 may each include a dielectric material. The first to third passivation layers BF1, BF2 and BF3 may each include silicon oxide, silicon nitride, or a combination thereof. The first conductive line BL, the second conductive lines DWL, and the data storage elements CAP may be electrically disconnected from the lower structure LS by the first to third passivation layers BF1, BF2 and BF3. The first to third passivation layers BF1, BF2 and BF3 may be referred to as bottom dielectric layers or bottom passivation layers. A dummy structure DS may be disposed between the first passivation layers BF1 and the lowermost level inter-cell dielectric layer IL. According to another embodiment of the present disclosure, the first to third passivation layers BF1, BF2 and BF3 may be formed on the surface of the lower structure LS at a lower level than the dummy structure DS.

The first conductive lines BL may vertically extend in the first direction D1 from the upper portion of the lower structure LS. The horizontal layers HL may extend in the second direction D2 that intersects with the first direction D1. The second conductive lines DWL may extend in the third direction D3 that intersects with the first direction D1 and the second direction D2.

From the perspective of a top view, the horizontal layers HL may each have a cross shape or rhombus shape. According to another embodiment of the present disclosure, the side surfaces of the horizontal layer HL may have a bent shape or a rounded shape. As illustrated in FIG. 1B, the horizontal layer HL may include the channel CH, a first doped region SR between the channel CH and the first conductive line BL, and a second doped region DR between the channel CH and the data storage element CAP.

A first capping layer BC may be disposed between the second conductive line DWL and the first conductive line BL. A second capping layer CC may be disposed between the second conductive line DWL and a first electrode SN of the data storage element CAP. The first capping layer BC may be disposed between an upper horizontal line G1 and the first conductive line BL. In addition, the first capping layer BC may be disposed between a lower horizontal line G2 and the first conductive line BL. The second capping layer CC may be disposed between the upper horizontal line G1 and the first electrode SN of the data storage element CAP. In addition, the second capping layer CC may be disposed between the lower horizontal line G2 and the first electrode SN of the data storage element CAP. One memory cell MC may include a pair of first capping layers BC and a pair of second capping layers CC.

The first and second capping layers BC and CC may each include a dielectric material. The first and second capping layers BC and CC may each include silicon oxide, silicon nitride, silicon carbon oxide, an air gap, or a combination thereof. The first capping layer BC may include a stack of a first capping liner BC1 and a first capping gap-fill layer BC2. The first capping liner BC1 may include silicon oxide, and the first capping gap-fill layer BC2 may include silicon nitride. The first capping gap-fill layer BC2 is disposed in the first capping liner BC1. A portion of the first capping gap-fill layer BC2 may protrude from the inner side of the first capping liner BC1. The second capping layer CC may include a stack of a second capping liner CC1 and a second capping gap-fill layer CC2. The second capping liner CC1 may include silicon oxide, and the second capping gap-fill layer CC2 may include silicon nitride. The second capping liner CC1 may extend to cover outer surfaces of the first electrode SN. The first doped region SR of the horizontal layers HL may include a protrusion portion that is not covered by the first capping layers BC. The second doped region DR of the horizontal layers HL may include a recessed portion that is disposed between the second capping layers CC. The first and second capping layers BC and CC may be referred to as first and second spacer layers.

The memory cell MC may further include a first contact node BLC and a second contact node SNC. The first contact node BLC may surround an outer wall of the first conductive line BL. The second contact node SNC may be disposed between the horizontal layer HL and the first electrode SN. The first contact node BLC may include a metal, a metal-based material or a semiconductor material. The second contact node SNC may include a metal, a metal-based material or a semiconductor material. For example, the first and second contact nodes BLC and SNC may each include titanium, titanium nitride, tungsten, or a combination thereof. In addition, the first and second contact nodes BLC and SNC may each include doped polysilicon, and the first doped region SR and the second doped region DR may include impurities diffused from the first contact node BLC and the second contact node SNC, respectively. The first contact node BLC may vertically extend in the first direction D1, and the memory cells MC stacked in the first direction D1 may share one first contact node BLC. The second contact node SNC may be coupled to each of the memory cells MC stacked in the first direction D1. The second contact node SNC may extend to cover the second capping gap-fill layer CC2 of the second capping layer CC.

The horizontal layers HL of switching elements TR horizontally disposed in the third direction D3 may share one second conductive line DWL. The horizontal layers HL of the switching elements TR horizontally disposed in the third direction D3 may be coupled to different first conductive lines BL. The switching elements TR stacked in the first direction D1 may share one first conductive line BL. The switching elements TR horizontally disposed in the third direction D3 may share one second conductive line DWL.

The first cell isolation layers ISOA may be disposed between the first electrodes SN of the data storage elements CAP in the third direction D3. The first electrodes SN may be isolated from one another by the first cell isolation layers ISOA. The second electrodes PN of the data storage elements CAP may be coupled to a common plate PL.

The data storage element CAP may include the first electrode SN, a dielectric layer DE, and the second electrode PN. The first electrode SN may have a semi-cylindrical shape.

The lower structure LS may include a semiconductor substrate, a metal wiring structure, a dielectric structure, a conductive structure, a bonding pad structure, other memory, or a peripheral circuit portion.

For example, the lower structure LS may include a structure in which the peripheral circuit portion, the metal wiring structure, and the bonding pad structure are sequentially stacked. The memory cell array MCA and the peripheral circuit portion of the lower structure LS may be combined by wafer bonding.

The peripheral circuit portion of the lower structure LS may be disposed at a lower level than the memory cell array MCA. This may be referred to as a cell-over-peripheral (COP) structure. The peripheral circuit portion may include at least one control circuit for driving the memory cell array MCA. The at least one control circuit of the peripheral circuit portion may include an N-channel transistor, a P-channel transistor, a CMOS circuit, or a combination thereof. The at least one control circuit of the peripheral circuit portion may include an address decoder circuit, a read circuit, and a write circuit. The at least one control circuit of the peripheral circuit portion may include a planar channel transistor, a recessed channel transistor, a buried gate transistor, and a fin channel transistor (FinFET).

For example, the peripheral circuit portion may include sub-word line drivers and a sense amplifier. The first conductive line BL may be coupled to the sense amplifier, and the second conductive lines DWL may be coupled to the sub-word line drivers.

According to another embodiment of the present disclosure, the peripheral circuit portion may be disposed at a higher level than the memory cell array MCA. This may be referred to as a peripheral-over-cell (POC) structure, and the peripheral circuit portion may be formed on another semiconductor substrate. In the POC structure, the metal wiring structure and the bonding pad structure may be disposed between the peripheral circuit portion and the memory cell array MCA. The memory cell array MCA and the peripheral circuit portion may be combined by wafer bonding.

According to another embodiment of the present disclosure, the memory cell array MCA may include a dynamic random-access memory (DRAM), an embedded DRAM, a NAND, a ferroelectric random-access memory (FeRAM), a spin transfer torque RAM (STTRAM), a phase-change RAM (PCRAM), or a resistive RAM (ReRAM).

According to another embodiment of the present disclosure, each memory cell MC may be replaced with the memory cell MC1 shown in FIG. 1D.

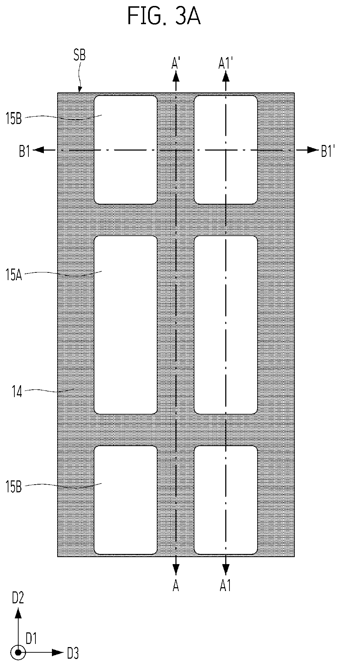

FIGS. 3A to 25B illustrate various views of a semiconductor device formed utilizing a method for fabricating the semiconductor device in accordance with an embodiment of the present disclosure.

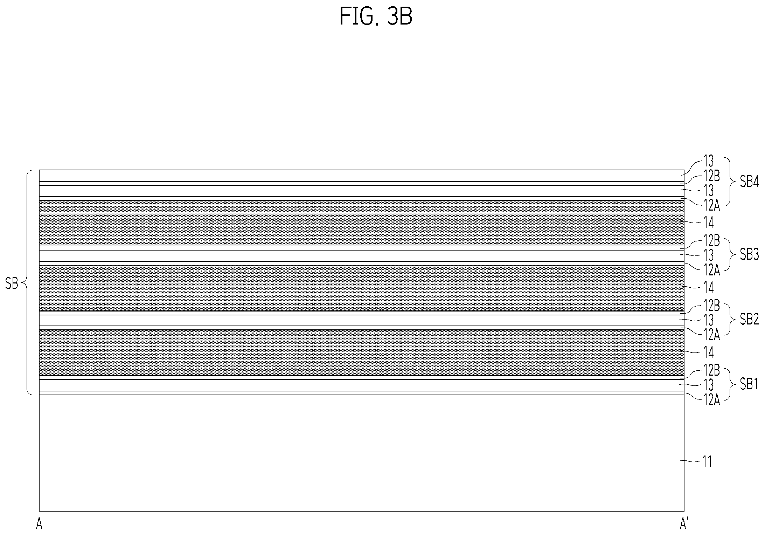

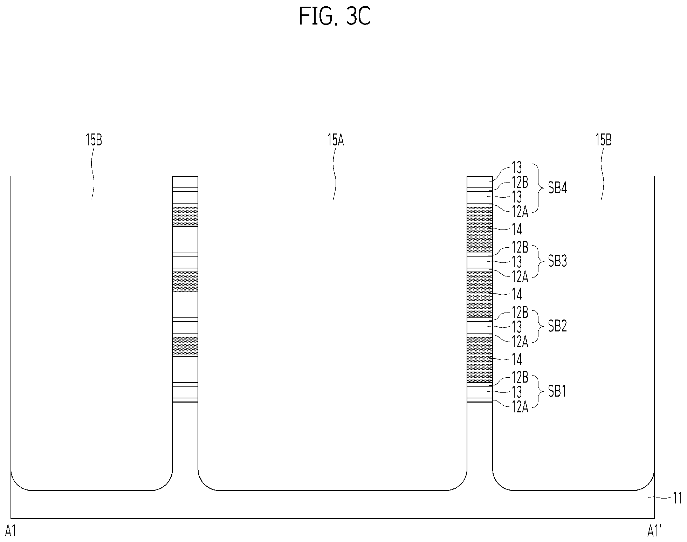

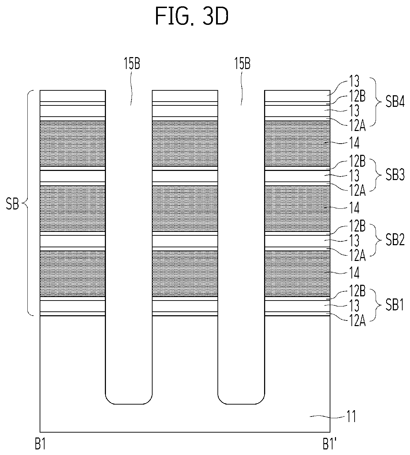

FIG. 3A is a plan view illustrating a structure with a fourth layer 14 for describing a method for forming a stack body SB and sacrificial isolation openings 15A and 15B, and FIG. 3B is a cross-sectional view illustrating the structure taken along line A-A' shown in FIG. 3A. FIG. 3C is a cross-sectional view illustrating the structure taken along line A1-A1' shown in FIG. 3A. FIG. 3D is a cross-sectional view illustrating the structure taken along line B-B' shown in FIG. 3A.

As illustrated in FIGS. 3A to 3D, the stack body SB may be formed over a lower structure 11. The lower structure 11 may be a material appropriate for semiconductor processing. The lower structure 11 may include at least one or more of conductive material, dielectric material and semiconductive material. Diverse materials may be formed over the lower structure 11. The lower structure 11 may include a semiconductor substrate. The lower structure 11 may be formed of a material containing silicon. The lower structure 11 may include silicon, monocrystalline silicon, polysilicon, amorphous silicon, silicon germanium, monocrystalline silicon germanium, polycrystalline silicon germanium, carbon-doped silicon, a combination thereof, or multi-layers thereof. The lower structure 11 may also include another semiconductor material such as germanium. The lower structure 11 may also include a III/V-group semiconductor substrate, for example, a compound semiconductor substrate such as GaAs. The lower structure 11 may include a silicon-on-insulator (SOI) substrate. The lower structure 11 may be referred to as a base body.

The stack body SB may include a plurality of sub-stacks that are alternately stacked with one another. Each of the sub-stacks may include a first layer 12A, a second layer 13, a third layer 12B, and a fourth layer 14 that are stacked in the mentioned order. The first layer 12A and the third layer 12B may be formed of the same material and include silicon germanium or monocrystalline silicon germanium. The first layer 12A, the second layer 13, the third layer 12B, and the fourth layer 14 may be formed by an epitaxial growth process. The first layer 12A at the lowermost level may serve as a seed layer during the epitaxial growth process. The first layer 12A may be thinner than the second layer 13, and the fourth layer 14 may be thicker than the second layer 13.

According to an embodiment of the present disclosure, the stack body SB may include a plurality of fourth layers 14, a first stack SB1, a second stack SB2, a third stack SB3, and a fourth stack SB4. The stack body SB may include the first stack SB1, the fourth layer 14, the second stack SB2, the fourth layer 14, the third stack SB3, and the fourth layer 14, and the fourth stack SB4 that are stacked in the mentioned order. The second layer 13 may be disposed at the uppermost level of the stack body SB. Each of the first to third stacks SB1 to SB3 may be a three-layer stack of the first layer 12A/the second layer 13/the third layer 12B. For example, when the first layer 12A and the third layer 12B include a silicon germanium layer and the second layer 13 includes a monocrystalline silicon layer, the first to third stacks SB1 to SB3 may each include a stack (SiGe/Si/SiGe) of first silicon germanium/monocrystalline silicon/second silicon germanium. The fourth stack SB4 may further include the second layer 13 over the three-layer stack of the first layer 12A/the second layer 13/the third layer 12B.

The second layer 13 may include a first monocrystalline silicon layer, and the fourth layer 14 may include a second monocrystalline silicon layer. The second monocrystalline silicon layer may be thicker than the first monocrystalline silicon layer. Accordingly, in the stack body SB, the first stack SB1 may be disposed below the second monocrystalline silicon layer, and the second stack SB2 may be disposed over the second monocrystalline silicon layer. Each of the first and second stacks SB1 and SB2 may include a stack of a first silicon germanium layer/a first monocrystalline silicon layer/a second silicon germanium layer.

The first layer 12A, the second layer 13 and the third layer 12B may be referred to as sacrificial layers, and the fourth layer 14 may be referred to as a recess target layer. The stack body SB may be referred to as an initial vertical stack. The stack body SB may be formed by alternately stacking a plurality of sacrificial layers with a plurality of recess target layers. The sacrificial layers may include the first stack SB1, the second stack SB2, the third stack SB3, and the fourth stack SB4, and each of the first stack SB1, the second stack SB2, the third stack SB3 and the fourth stack SB4 may include the three-layer stack of the first layer 12A/the second layer 13/the third layer 12B. The recess target layer may include the fourth layer 14. Each of the sacrificial layers may include a three-layer stack of a first silicon germanium layer/a first monocrystalline silicon layer/a second silicon germanium layer, and the recess target layer may include a single layer of a second monocrystalline silicon layer, and the second monocrystalline silicon layer may be thicker than the first monocrystalline silicon layer.

As described above with reference to FIGS. 2A and 2B, when the memory cells MC are vertically stacked, the first stack SB1, the fourth layer 14, the second stack SB2, and the fourth layer 14 may be alternately stacked several times.

Subsequently, portions of the stack body SB may be etched to form a plurality of sacrificial isolation openings 15A and 15B. The sacrificial isolation openings 15A and 15B, which are initial openings for cell isolation, may include large openings 15A and small openings 15B. The size of the large openings 15A may be larger than that of the small openings 15B. From the perspective of a top view, the large openings 15A and the small openings 15B may each have a rectangular shape. The large openings 15A and the small openings 15B may each have a rectangular shape with rounded corners. According to another embodiment of the present disclosure, the large openings 15A and the small openings 15B may each have a circular shape or an oval shape. According to another embodiment of the present disclosure, the sacrificial isolation openings 15A and 15B may be referred to as sacrificial isolation trenches. The large openings 15A and the small openings 15B may vertically extend in a first direction D1. The large openings 15A and the small openings 15B may be alternately disposed in a second direction D2. A plurality of large openings 15A may be disposed in a third direction D3. A plurality of small openings 15B may be disposed in the third direction D3. The large openings 15A and the small openings 15B may penetrate the stack body SB in the first direction D1.

After the sacrificial isolation openings 15A and 15B are formed, portions of the lower structure 11 exposed below the sacrificial isolation openings 15A and 15B may be etched. Accordingly, the lower surfaces of the sacrificial isolation openings 15A and 15B may extend inside the low structure 11. The lower surfaces of the sacrificial isolation openings 15A and 15B may each include a U-shape profile. The fourth layers 14 may each have a mesh-shape pattern by the sacrificial isolation openings 15A and 15B.

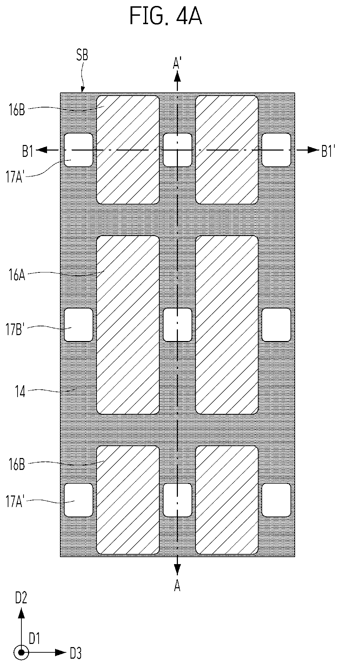

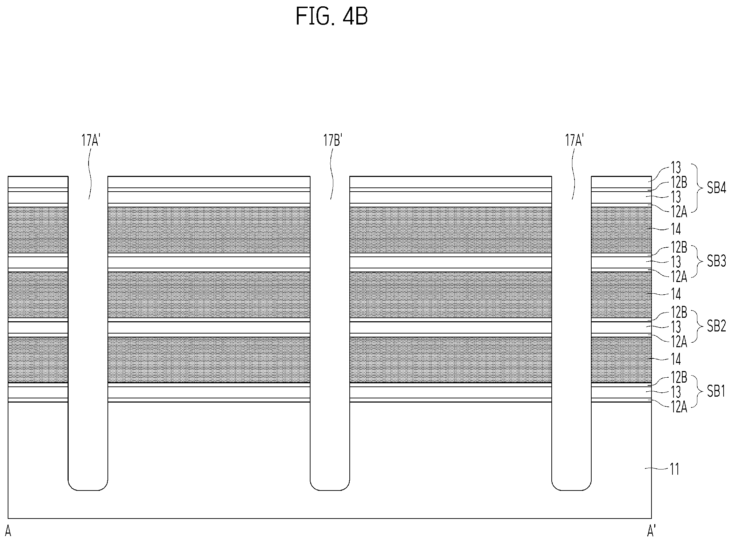

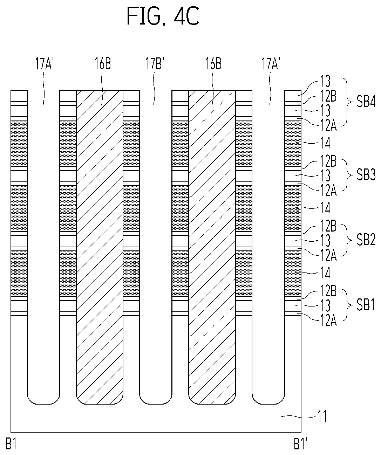

FIG. 4A is a plan view illustrating the structure with the fourth layer 14 for describing a method for forming initial sacrificial vertical openings 17A' and 17B', and FIG. 4B is a cross-sectional view illustrating the structure taken along line A-A' illustrated in FIG. 4A. FIG. 4C is a cross-sectional view illustrating the structure taken along line B1-B1' illustrated in FIG. 4A.

As illustrated in FIGS. 4A to 4C, sacrificial isolation layers 16A and 16B may be formed to fill the sacrificial isolation openings 15A and 15B. The sacrificial isolation layers 16A and 16B may include first sacrificial isolation layers 16A and second sacrificial isolation layers 16B. The first sacrificial isolation layers 16A may fill the large openings 15A, and the second sacrificial isolation layers 16B may fill the small openings 15B.

The first sacrificial isolation layers 16A and the second sacrificial isolation layers 16B may include the same material. The first sacrificial isolation layers 16A and the second sacrificial isolation layers 16B may be formed of a dielectric material. For example, the first sacrificial isolation layers 16A and the second sacrificial isolation layers 16B may include silicon oxide, silicon nitride, silicon carbon oxide, silicon carbon nitride, or a combination thereof. Forming the first sacrificial isolation layers 16A and the second sacrificial isolation layers 16B may include forming sacrificial isolation materials on the stack body SB to fill the sacrificial isolation openings 15A and 15B and planarizing the sacrificial isolation materials so that the uppermost layer of the stack body SB is exposed. The first sacrificial isolation layers 16A and the second sacrificial isolation layers 16B may have different sizes or different volumes. For example, the size or volume of the first sacrificial isolation layers 16A may be larger than that of the second sacrificial isolation layers 16B. The first sacrificial isolation layers 16A and the second sacrificial isolation layers 16B may have the same length in the third direction D3 and have different lengths in the second direction D2. The length of the first sacrificial isolation layers 16A in the second direction D2 may be larger than that of the second sacrificial isolation layers 16B.

The first sacrificial isolation layers 16A and the second sacrificial isolation layers 16B may vertically extend in the first direction D1. The first sacrificial isolation layers 16A and the second sacrificial isolation layers 16B may be alternately disposed in the second direction D2. A plurality of first sacrificial isolation layers 16A may be disposed in the third direction D3. A plurality of second sacrificial isolation layers 16B may be disposed in the third direction D3. The first sacrificial isolation layers 16A and the second sacrificial isolation layers 16B may penetrate the stack body SB in the first direction D1.

Subsequently, portions of the stack body SB may be etched. Accordingly, a plurality of initial sacrificial vertical openings 17A' and 17B' may be formed in the stack body SB. The initial sacrificial vertical openings 17A' and 17B' may include first initial sacrificial vertical openings 17A' and second initial sacrificial vertical openings 17B'. From the perspective of a top view, the first and second initial sacrificial vertical openings 17A' and 17B' may be hole-shape openings. The first and second initial sacrificial vertical openings 17A' and 17B' may vertically extend in the first direction D1. The first and second initial sacrificial vertical openings 17A' and 17B' may be formed by etching the stack body SB between the first sacrificial isolation layers 16A and the second sacrificial isolation layers 16B. The first initial sacrificial vertical openings 17A' may be formed by etching the stack body SB between the second sacrificial isolation layers 16B. The second initial sacrificial vertical openings 17B' may be formed by etching the stack body SB between the first sacrificial isolation layers 16A. The first initial sacrificial vertical openings 17A' may be disposed between the second sacrificial isolation layers 16B in the third direction D3. The second initial sacrificial vertical openings 17B' may be disposed between the first sacrificial isolation layers 16A in the third direction D3. From the perspective of a top view, the cross-sectional surfaces of the first and second initial sacrificial vertical openings 17A' and 17B' may have a square shape, a square shape with rounded corners, a circular shape, or an oval shape. The first and second initial sacrificial vertical openings 17A' and 17B' may not contact the sacrificial isolation layers 16A and 16B.

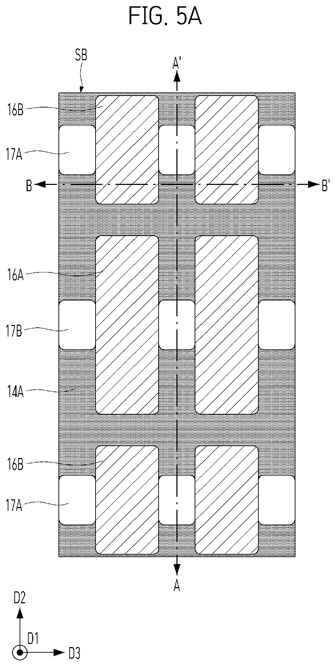

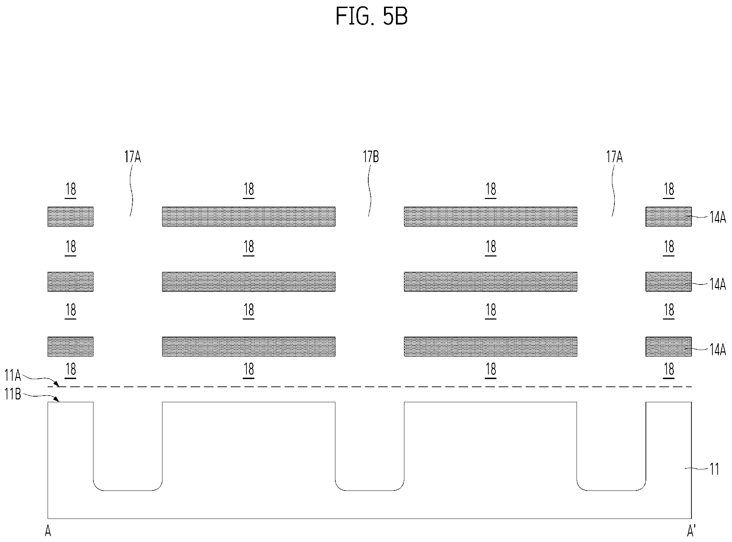

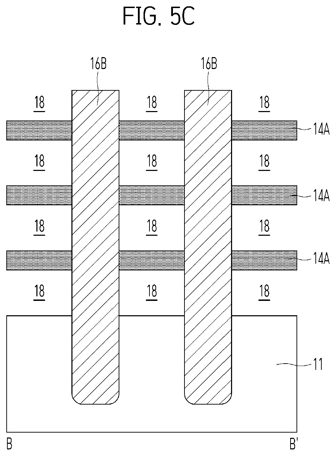

FIG. 5A is a plan view illustrating the structure with a preliminary horizontal layer 14A for describing a method for forming the preliminary horizontal layer 14A, and FIG. 5B is a cross-sectional view illustrating the structure taken along line A-A' illustrated in FIG. 5A. FIG. 5C is a cross-sectional view illustrating the structure taken along line B-B' illustrated in FIG. 5A.

As illustrated in FIG. 5A to 5C, the first and third layers 12A and 12B may be selectively removed through the first and second initial sacrificial vertical openings 17A' and 17B'. To selectively remove the first layers 12A and the third layers 12B, a difference in etch selectivity between the second and fourth layers 13 and 14 and the first and third layers 12A and 12B may be used. The first layers 12A and the third layers 12B may be removed using a wet etching process or a dry etching process. For example, when the first layers 12A and the third layers 12B include silicon germanium layers and the second layers 13 and the fourth layers 14 include monocrystalline silicon layers, the silicon germanium layers may be etched using an etchant or etching gas that has a selectivity with respect to the monocrystalline silicon layers.

Subsequently, the second layers 13 and the fourth layers 14 may be recessed. To recess the second layers 13 and the fourth layers 14, a wet etching process or a dry etching process may be used. According to an embodiment of the present disclosure, the fourth layers 14 may be partially etched while the second layers 13 are removed. Accordingly, the second layers 13 may be removed, and the fourth layers 14 may be thinned as indicated by reference numeral "14A". The recess process for forming the thinned fourth layers 14A, i.e., the preliminary horizontal layers 14A, may be referred to as a thinning process or trimming process of the fourth layers 14. To form the preliminary horizontal layers 14A, the upper surfaces, lower surfaces, and side surfaces of the fourth layers 14 may be recessed. The preliminary horizontal layers 14A may be referred to as thin-body active layers. The preliminary horizontal layers 14A may each include a monocrystalline silicon layer. The recess process for forming the preliminary horizontal layers 14A may use, for example, HSC1 (Hot SC-1). The HSC1 may include a solution in which ammonium hydroxide (NH₄OH), hydrogen peroxide (H₂O₂), and water (H₂O) are mixed in a ratio of 1:4:20. Using the HSC1, the second layers 13 and the fourth layers 14 may be selectively etched.

The preliminary horizontal layers 14A may be formed by the recess process for the fourth layers 14 as described above, and horizontal recesses 18 may be formed between the preliminary horizontal layers 14A. The upper and lower surfaces of the preliminary horizontal layers 14A may each include a flat surface.

From the perspective of a top view, the preliminary horizontal layers 14A may have a cross shape. The side surfaces of the preliminary horizontal layers 14A may have a bent shape or a rounded shape. The preliminary horizontal layer 14A of one level or tier may have a shape in which a plurality of cross shapes are merged in the third direction D3.

After the preliminary horizontal layers 14A are formed, the first and second initial sacrificial vertical openings may be expanded into first and second sacrificial vertical openings as indicated by reference numerals 17A and 17B. The preliminary horizontal layers 14A may be spaced apart from one another by the first and second sacrificial vertical openings 17A and 17B in the second direction D2.

While the preliminary horizontal layers 14A are formed, a surface 11A of the lower structure 11 may be recessed to a predetermined depth (refer to reference numeral "11B"). Accordingly, the depth of the first and second sacrificial vertical openings 17A and 17B may increase.

The first sacrificial vertical openings 17A may be alternately disposed with the second sacrificial vertical openings 17B between the preliminary horizontal layers 14A in the second direction D2. The first sacrificial vertical openings 17A may be disposed between the second sacrificial isolation layers 16B in the third direction D3, and the second sacrificial vertical openings 17B may be disposed between the first sacrificial isolation layers 16A in the third direction D3.

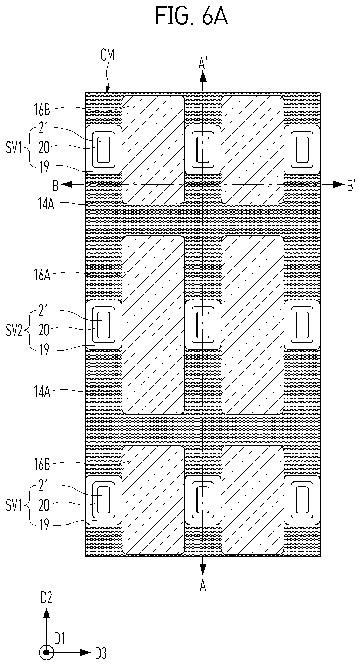

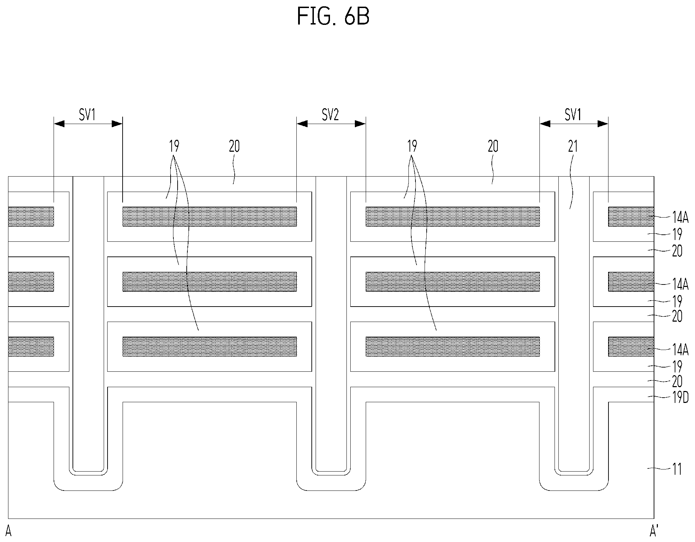

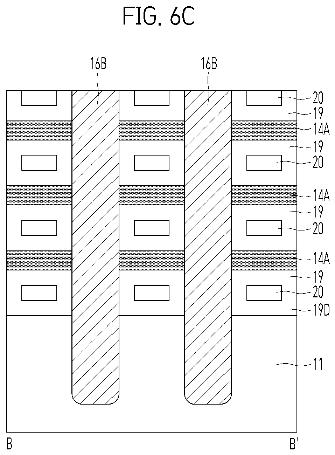

FIG. 6A is a plan view illustrating the structure with a first dielectric layer 19 and a second dielectric layer 20 for describing a method for forming the first and second dielectric layers 19 and 20, and FIG. 6B is a cross-sectional view illustrating the structure taken along line A-A' illustrated in FIG. 6A. FIG. 6C is a cross-sectional view illustrating the structure taken along line B-B' illustrated in FIG. 6A.

As illustrated in FIGS. 6A to 6C, the first dielectric layers 19 may be formed to cover the preliminary horizontal layers 14A. The first dielectric layers 19 may include silicon nitride. The first dielectric layers 19 may fully cover the upper, lower, and side surfaces of the preliminary horizontal layers 14A.

While the first dielectric layers 19 are formed, a dummy dielectric layer 19D may be formed on the surface of the lower structure 11.

Subsequently, second dielectric layers 20 may be formed on the first dielectric layers 19. Each of the second dielectric layers 20 may fill between the vertically neighboring first dielectric layers 19. The second dielectric layer 20 may include silicon oxide. Portions of the second dielectric layer 20 may be formed conformally on the surfaces of the first and second sacrificial vertical openings 17A and 17B. The horizontal recesses (reference numeral "18" of FIGS. 5A to 5C) may be filled with the first dielectric layers 19 and the second dielectric layers 20.

Subsequently, a sacrificial pillar 21 may be formed on the second dielectric layer 20 disposed in the first and second sacrificial vertical openings 17A and 17B. The sacrificial pillar 21, which is a sacrificial material, may include amorphous carbon. According to another embodiment of the present disclosure, a pillar capping layer may be further formed over the sacrificial pillar 21. The pillar capping layer may include a metal, or a metal-based material. The pillar capping layer may include titanium nitride. Forming the sacrificial pillar 21 may include depositing a sacrificial material and planarizing the sacrificial material. The planarization process for forming the sacrificial pillar 21 may be performed until the uppermost-level first dielectric layer 19 is exposed. Subsequently, the uppermost-level second dielectric layers 20 may be planarized until the uppermost-level first dielectric layer 19 is exposed. The sacrificial pillar 21 may not be formed between the first dielectric layers 19 which are vertically stacked.

The second dielectric layer 20 and the sacrificial pillar 21 may form first and second sacrificial pillar structures SV1 and SV2 that fill the first and second sacrificial vertical openings 17A and 17B. The first sacrificial pillar structure SV1 may fill the first sacrificial vertical openings 17A, and the second sacrificial pillar structure SV2 may fill the second sacrificial vertical openings 17B. According to another embodiment of the present disclosure, the first and second sacrificial pillar structures SV1 and SV2 may include a dielectric material, a carbon-containing material, a metal-based material, or a combination thereof. According to another embodiment of the present disclosure, the first and second sacrificial pillar structures SV1 and SV2 may include silicon oxide, silicon nitride, titanium nitride, amorphous carbon, or a combination thereof. From the perspective of a top view, the first sacrificial pillar structure SV1 and the second sacrificial pillar structure SV2 may be hole-shape sacrificial pillars. According to another embodiment of the present disclosure, portions of the first dielectric layer 19 may be conformally formed on the surfaces of the first and second sacrificial vertical openings 17A and 17B, and thus the first and second sacrificial pillar structures SV1 and SV2 may further include the portions of the first dielectric layer 19.

Referring to FIG. 6C, the first dielectric layer 19 may be formed between the preliminary horizontal layers 14A, and the second dielectric layer 20 may be disposed in the first dielectric layer 19. The first dielectric layer 19 may surround the second dielectric layer 20. The first dielectric layer 19 may include a first surrounding portion and a second surrounding portion. The first surrounding portion may surround the preliminary horizontal layer 14A in an A-A' direction, and the second surrounding portion may surround the second dielectric layer 20 in a B-B' direction.

As described above, by forming the preliminary horizontal layers 14A, the first dielectric layers 19, and the second dielectric layers 20, a cell mold structure may be formed. The cell mold structure may include a plurality of cell molds CM. Each of the cell molds CM may include a plurality of mold layers. The mold layers may refer to the preliminary horizontal layers 14A, the first dielectric layers 19 and the second dielectric layers 20. Each of the cell molds CM may include an ONSN (Oxide-Nitride-Silicon-Nitride) stack. The ONSN stack may refer to a structure in which silicon oxide, first silicon nitride, a monocrystalline silicon layer, and second silicon nitride are sequentially stacked. The silicon oxide may correspond to the second dielectric layers 20, and the first and second silicon nitride may correspond to the first dielectric layers 19, and the monocrystalline silicon layer may correspond to the preliminary horizontal layers 14A. The cell mold structure including the plurality of cell molds CM may be referred to as a vertical stack. From another perspective, the cell mold structure may include an ONSNO (Oxide-Nitride-Silicon-Nitride-Oxide) stack. The ONSNO stack may refer to a structure in which first silicon oxide, first silicon nitride, a monocrystalline silicon layer, second silicon nitride, and second silicon oxide are sequentially stacked.

As described above, through a series of the processes according to FIGS. 4A to 6C, the sub-stacks of the stack body SB may be replaced with the cell molds CM. The first layers 12A, the second layers 13, and the third layers 12B may be replaced with the first dielectric layers 19 and the second dielectric layers 20. The fourth layers 14 may become the preliminary horizontal layers 14A by the recess process. The first dielectric layers 19 may be referred to as trimming target layers.

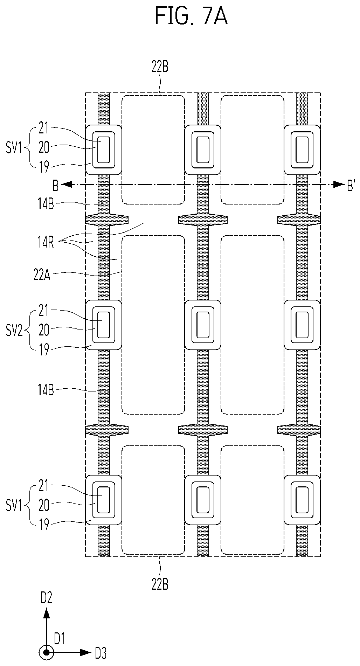

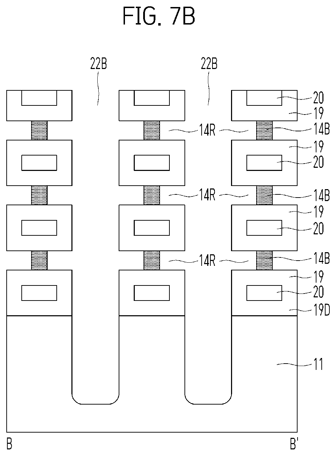

FIG. 7A is a plan view illustrating the structure with cell isolation openings 22A and 22B and horizontal layers 14B for describing a method for forming the cell isolation openings 22A and 22B and the horizontal layers 14B, and FIG. 7B is a cross-sectional view illustrating the structure taken along line B-B' illustrated in FIG. 7A.

As illustrated in FIGS. 7A and 7B, the first and second sacrificial isolation layers 16A and 16B may be removed to form the cell isolation openings 22A and 22B. The cell isolation openings 22A and 22B may include first cell isolation openings 22A and second cell isolation openings 22B. The first cell isolation openings 22A may be formed by removing the first sacrificial isolation layers 16A. The second cell isolation openings 22B may be formed by removing the second sacrificial isolation layers 16B. While the first and second sacrificial isolation layers 16A and 16B are removed, the first and second sacrificial pillar structures SV1 and SV2 may be covered by a mask layer (not illustrated). The side surfaces of the preliminary horizontal layers 14A and first dielectric layers 19 may be exposed by the first and second cell isolation openings 22A and 22B in a line B-B' direction.

Subsequently, the side surfaces of the preliminary horizontal layers 14A may be trimmed through the first and second cell isolation openings 22A and 22B in the second direction D2 and the third direction D3. Accordingly, the trimmed horizontal layers 14B may be formed. Horizontal layer level gaps 14R may be formed on both sides of the horizontal layers 14B. The horizontal layer level gaps 14R and the horizontal layers 14B may be disposed between the first dielectric layers 19. The horizontal layers 14B may be referred to as trimmed horizontal layer patterns.

While the horizontal layers 14B are formed, the surface of the lower structure 11, for example, the lower surfaces of the cell isolation openings 22A and 22B, may be expanded.

The horizontal layers 14B may be disposed between the first sacrificial pillar structure SV1 and the second sacrificial pillar structure SV2 in the second direction D2. From the perspective of a top view, the horizontal layers 14B may each have a cross shape. The horizontal layers 14B may each have a cross shape with a smaller size than the preliminary horizontal layers 14A. The preliminary horizontal layers (reference numeral "14A" of FIG. 6A) may each have a shape in which a plurality of cross shapes are merged, and the horizontal layers (reference numeral "14B" of FIG. 7A) may each have a shape in which the cross shapes are individually isolated in the third direction D3. The horizontal layer level gaps 14R may be formed between the horizontal layers 14B disposed in the third direction D3. The first and second sacrificial pillar structures SV1 and SV2 may be disposed between the horizontal layers 14B in the second direction D2.

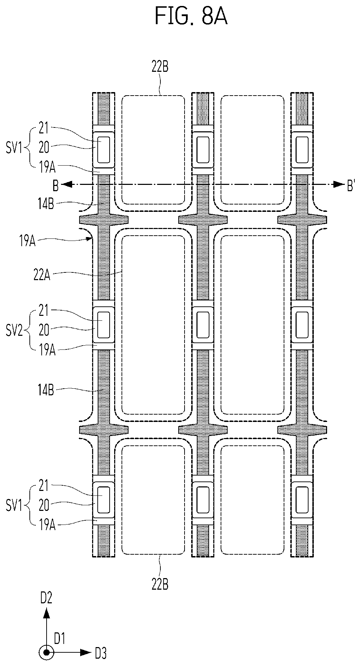

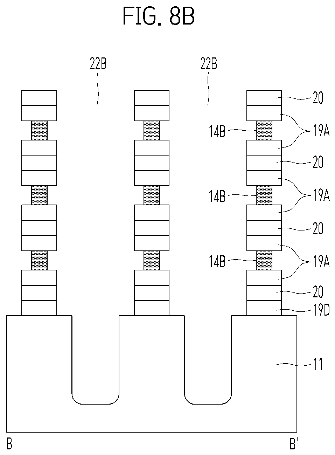

FIG. 8A is a plan view illustrating the structure with first dielectric layer 19A for describing a method for forming the first dielectric layer 19A, and FIG. 8B is a cross-sectional view illustrating the structure taken along line B-B' illustrated in FIG. 8A.

As illustrated in FIGS. 8A and 8B, portions of the first dielectric layers 19 may be horizontally trimmed through the first and second cell isolation openings 22A and 22B. After the trimming process, the first dielectric layers 19 may remain as indicated by reference numeral "19A". Accordingly, when viewed from line B-B', a pair of first dielectric layers 19A may be disposed between the horizontal layers 14B, and one second dielectric layer 20 may be disposed between a pair of first dielectric layers 19A.

According to another embodiment of the present disclosure, horizontal layer level spacers may be formed on the side surfaces of the horizontal layers 14B before the first dielectric layers 19 are trimmed. Forming the horizontal layer level spacers may include forming a spacer material on the side surfaces of the horizontal layers 14B and etching the spacer material. The horizontal layer level spacers may include a dielectric material, for example, silicon oxide. The horizontal layer level spacers may fill the horizontal layer level gaps 14R. The horizontal layers 14B disposed in the third direction D3 may be isolated from each other by the horizontal layer level spacers.

According to FIGS. 7A to 8B, the width of each of the first dielectric layers 19A in the third direction D3 between the first cell isolation openings 22A and the second cell isolation openings 22B may be greater than that of each of the horizontal layers 14B. Specifically, the trimming depth of each of the first dielectric layers 19 in the third direction D3 may be smaller than the trimming depth of each of the preliminary horizontal layers 14A.

A pair of first dielectric layers 19A may vertically overlap with one horizontal layer 14B. The first dielectric layers 19A which are trimmed may be referred to as trimmed first dielectric layers.

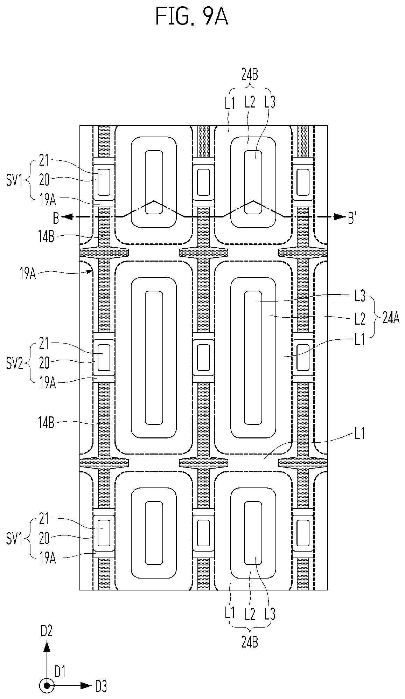

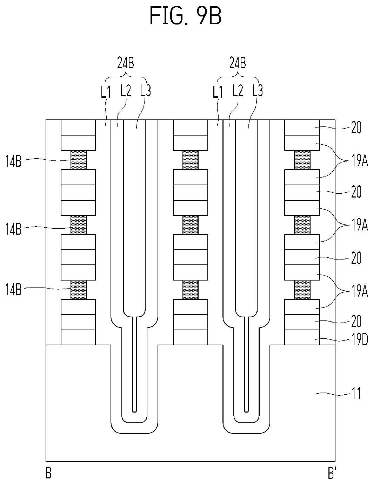

FIG. 9A is a plan view illustrating the structure with cell isolation layers 24A and 24B for describing a method for forming the cell isolation layers 24A and 24B, and FIG. 9B is a cross-sectional view illustrating the structure taken along line B-B' illustrated in FIG. 9A. FIG. 9A is a plan view illustrating the structure with the first dielectric layers 19A to describe the method for forming the cell isolation layers 24A and 24B.

As illustrated in FIGS. 9A and 9B, the cell isolation layers 24A and 24B may be formed to fill the cell isolation openings 22A and 22B. The cell isolation layers 24A and 24B may include first cell isolation layers 24A and second cell isolation layers 24B. The first cell isolation layers 24A and the second cell isolation layers 24B may include the same material. The first cell isolation layers 24A and the second cell isolation layers 24B may be formed of a dielectric material. For example, the first cell isolation layers 24A and the second cell isolation layers 24B may include silicon oxide, silicon nitride, silicon carbon oxide, silicon carbon nitride, or a combination thereof. From the perspective of a top view, the outermost material of the first cell isolation layers 24A and second cell isolation layers 24B may include silicon oxide.

Forming the first cell isolation layers 24A and the second cell isolation layers 24B may include forming a cell isolation material that fills the cell isolation openings 22A and 22B and planarizing the cell isolation material and the uppermost-level first dielectric layer 19A so that the surface of the hard mask layer pattern 17 is exposed. The first cell isolation layers 24A and the second cell isolation layers 24B may have different sizes or volumes. The first cell isolation layers 24A and the second cell isolation layers 24B may have a dual structure of silicon oxide and silicon carbon oxide. For example, silicon carbon oxide may be deposited after silicon oxide is deposited. According to another embodiment of the present disclosure, the first and second cell isolation layers 24A and 24B may include an embedded air gap, and the embedded air gap may be provided when silicon carbon oxide is deposited. The second sacrificial pillar structure SV2 may be disposed between the first cell isolation layers 24A in the third direction D3, and the first sacrificial pillar structure SV1 may be disposed between the second cell isolation layers 24B in the third direction D3. The first and second cell isolation layers 24A and 24B may vertically extend in the first direction D1.

The first and second cell isolation layers 24A and 24B may correspond to the cell isolation layers ISOA and ISOB as illustrated with reference to FIGS. 2A and 2B.

Each of the first and second cell isolation layers 24A and 24B may include a stack of a cell isolation liner layer L1, a stopper layer L2 and a cell isolation gap-fill layer L3. The cell isolation liner layer L1 may include silicon oxide, and the cell isolation gap-fill layer L3 may include silicon oxide or silicon carbon oxide. The stopper layer L2 may include silicon nitride. According to another embodiment of the present disclosure, the first and second cell isolation layers 24A and 24B may include an embedded air gap, and the embedded air gap may be provided when the cell isolation gap-fill layers L3 are formed.

From a top view perspective, the stopper layers L2 may surround the cell isolation gap-fill layers L3, and the cell isolation liner layers L1 may surround the stopper layers L2. The cell isolation liner layers L1 may contact the side surfaces of the horizontal layers 14B. The cell isolation liner layers L1 may fill the horizontal layer level gaps (reference numeral "14R" of FIG. 7B). The horizontal layers 14B disposed in the third direction D3 may be isolated from each other by the cell isolation liner layers L1. The cell isolation liner layers L1 may be in direct contact with the first dielectric layers 19A. The cell isolation liner layers L1 may be disposed between the horizontal layers 14B and the stopper layers L2.

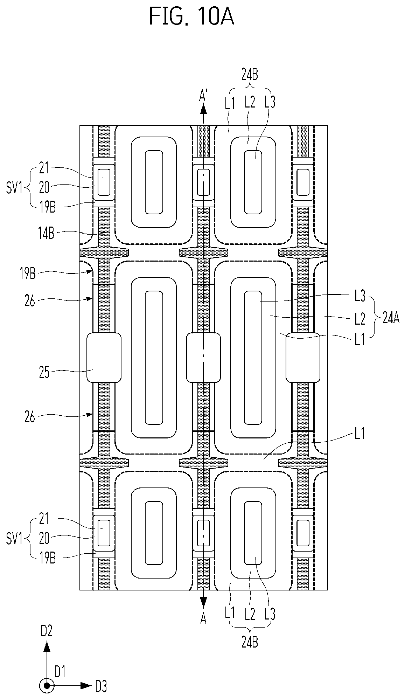

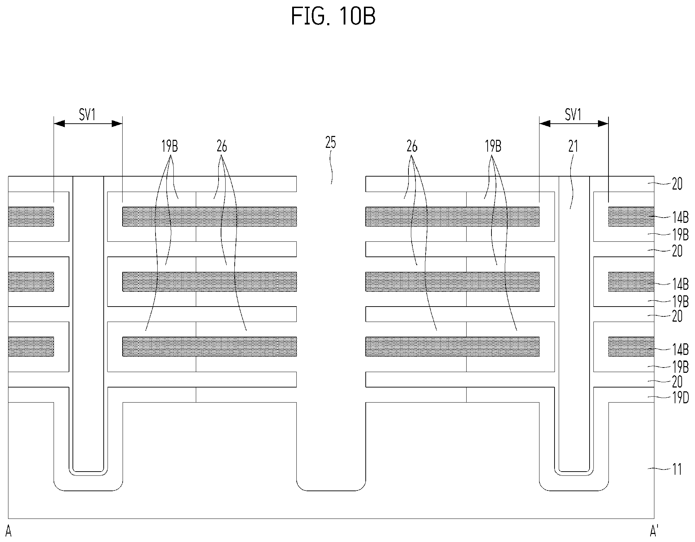

FIG. 10A is a plan view illustrating the structure with the first dielectric layer patterns 19B for describing a method for forming the first dielectric layer patterns 19B, and FIG. 10B is a cross-sectional view illustrating the structure taken along line A-A' illustrated in FIG. 10A.

As illustrated in FIGS. 10A and 10B, the second sacrificial pillar structures SV2 may be removed to form initial vertical openings 25.

Subsequently, the second dielectric layers 20 may be horizontally recessed. Accordingly, the first dielectric layers 19A and the dummy dielectric layer 19D may be exposed by the initial vertical openings 25.

Subsequently, the first dielectric layers 19A and the dummy dielectric layer 19D may be selectively and horizontally recessed. Accordingly, the first dielectric layer patterns 19B and dielectric layer level recesses 26 may be formed. Portions of the horizontal layers 14B may be exposed by the dielectric layer level recesses 26.

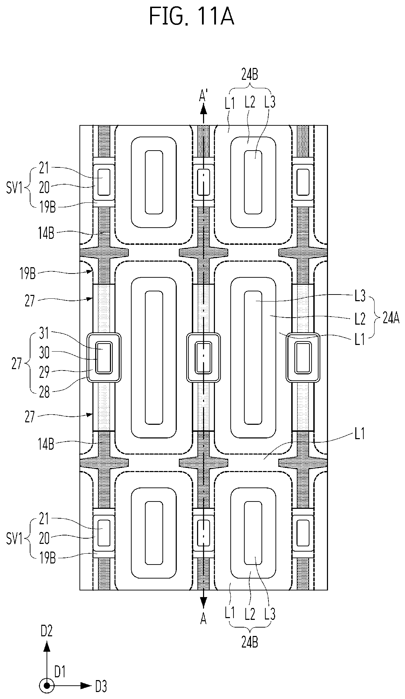

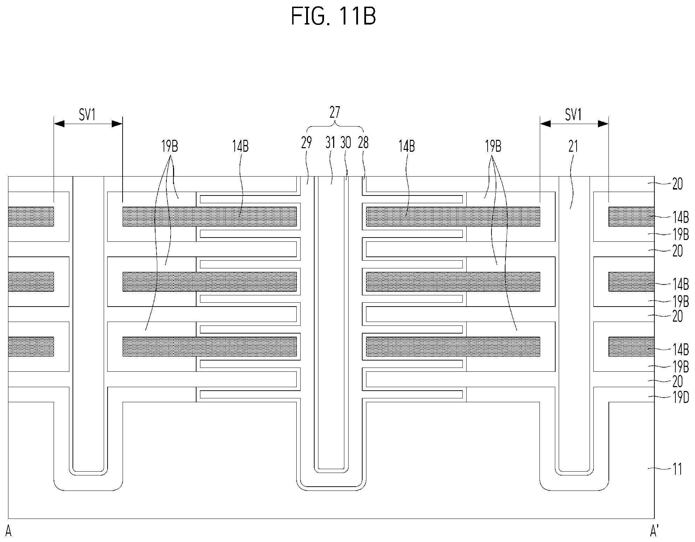

FIG. 11A is a plan view illustrating the structure with vertical sacrificial structures 27 for describing a method for forming the vertical sacrificial structures 27, and FIG. 11B is a cross-sectional view illustrating the structure taken along line A-A' illustrated in FIG. 11A.

As illustrated in FIGS. 11A and 11B, the vertical sacrificial structures 27 may be formed to fill the dielectric layer level recesses 26 and the initial vertical openings 25. The vertical sacrificial structures 27 may include a sacrificial material. The vertical sacrificial structures 27 may include silicon oxide, silicon nitride, titanium nitride, amorphous carbon, or a combination thereof. The vertical sacrificial structures 27 may each include a stack of a silicon oxide liner 28, a silicon nitride liner 29, silicon oxide 30 and titanium nitride 31. Each of the dielectric layer level recesses 26 may be filled with a stack of the silicon oxide liner 28 and the silicon nitride liner 29, and each of the initial vertical openings 25 may be filled with the stack of the silicon oxide liner 28, the silicon nitride liner 29, the silicon oxide 30 and the titanium nitride 31.

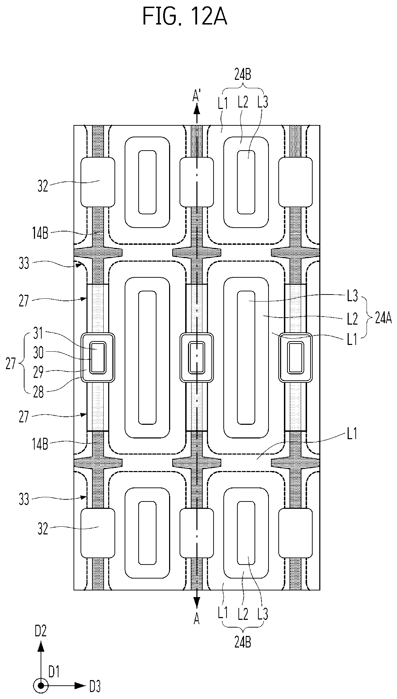

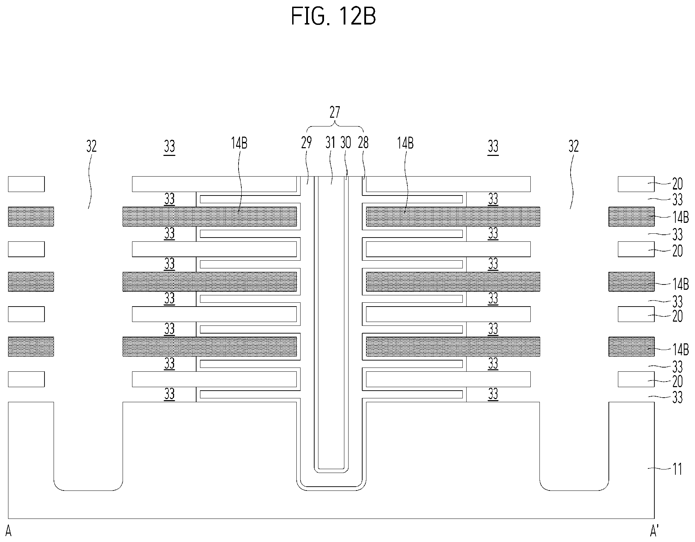

FIG. 12A is a plan view illustrating the structure with horizontal level recesses 33 for describing a method for forming the horizontal level recesses 33, and FIG. 12B is a cross-sectional view illustrating the structure taken along line A-A' illustrated in FIG. 12A.

As illustrated in FIGS. 12A and 12B, the first sacrificial pillar structures SV1 may be removed to form first hole-shape vertical openings 32. Subsequently, the second dielectric layers 20 may be cut through the first hole-shape vertical openings 32.

To form the horizontal level recesses 33, the first dielectric layer patterns 19B may be removed through the first hole-shape vertical openings 32. Portions of the horizontal layers 14B may be exposed by the horizontal level recesses 33. Cross-shape channel-to-be portions of the horizontal layers 14B may be exposed by the horizontal level recesses 33. Each of the horizontal level recesses 33 may be disposed between the second dielectric layer 20 and the horizontal layer 14B. Two horizontal level recesses 33 may face each other with one horizontal layer 14B interposed therebetween.

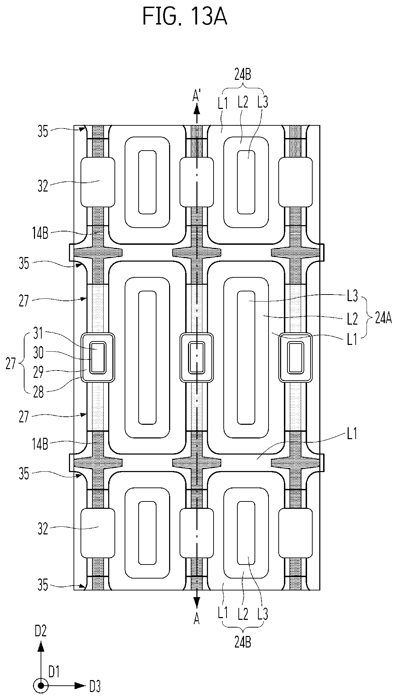

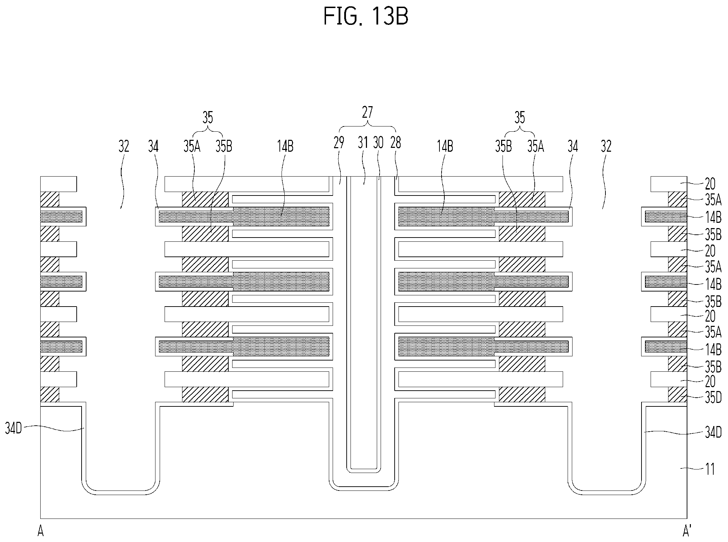

FIG. 13A is a plan view illustrating the structure with horizontal conductive lines 35 for describing a method for forming the horizontal conductive lines 35, and FIG. 13B is a cross-sectional view illustrating the structure taken along line A-A' illustrated in FIG. 13A.

As illustrated in FIGS. 13A and 13B, inter-level dielectric layers 34 may be formed on exposed portions of the horizontal layers 14B. The inter-level dielectric layers 34 may be referred to as gate dielectric layers. The inter-level dielectric layers 34 may correspond to the inter-level dielectric layers GD as illustrated with reference to FIGS. 1A to 2B.

The inter-level dielectric layers 34 may be formed by oxidizing the surfaces of the horizontal layers 14B. According to another embodiment of the present disclosure, the inter-level dielectric layers 34 may be formed by a deposition process of silicon oxide. The inter-level dielectric layers 34 may include silicon oxide, silicon nitride, metal oxide, metal oxide nitride, metal silicate, a high-k material, a ferroelectric material, an anti-ferroelectric material, or a combination thereof. The inter-level dielectric layers 34 may include SiO₂, Si₃N₄, HfO₂, Al₂O₃, ZrO₂, AlON, HfON, HfSiO, HfSiON, or a combination thereof. A first passivation layer 34D may be formed on the surface of the lower structure 11 while the inter-level dielectric layers 34 are formed.

Subsequently, the horizontal conductive lines 35 may be formed to fill the horizontal level recesses 33 on the inter-level dielectric layers 34. Forming the horizontal conductive lines 35 may include depositing a conductive material filling the horizontal level recesses 33 on the inter-level dielectric layers 34 and etching-back the conductive material. Each of the horizontal conductive lines 35 may include a pair of first and second horizontal conductive lines 35A and 35B that face each other with the horizontal layer 14B therebetween. The first and second horizontal conductive lines 35A and 35B may include a metal-base material, a semiconductor material, or a combination thereof. The first and second horizontal conductive lines 35A and 35B may include titanium nitride, tungsten, polysilicon, or a combination thereof. For example, the first and second horizontal conductive lines 35A and 35B may include a TiN/W stack in which titanium nitride and tungsten are sequentially stacked. The horizontal conductive lines 35A and 35B may include an N-type work function material or a P-type work function material. The N-type work function material may have a low work function of approximately 4.5 eV or lower, and the P-type work function material may have a high work function of approximately 4.5 eV or higher.

The horizontal conductive line 35 may correspond to the second conductive line DWL as illustrated in FIGS. 1A to 2B, and the first and second horizontal conductive lines 35A and 35B may correspond to the upper horizontal line G1 and the lower horizontal line G2, respectively. As illustrated in FIGS. 1A to 2B, each of the first and second horizontal conductive lines 35A and 35B may have a cross shape and include the channel overlapping portion WLP and the channel non-overlapping portion NOL.

While the horizontal conductive lines 35 are formed, dummy conductive lines 35D may be formed close to the lower structure 11.

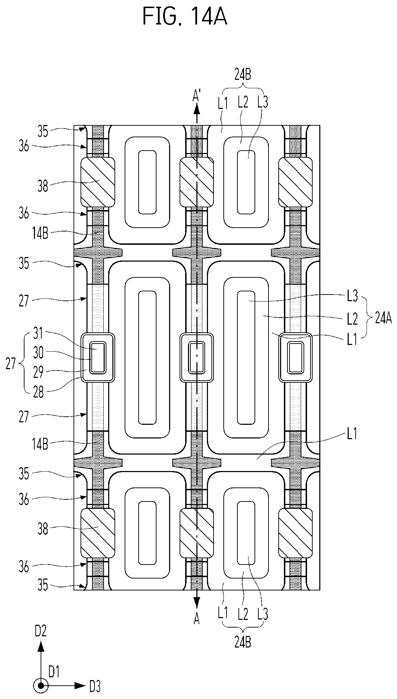

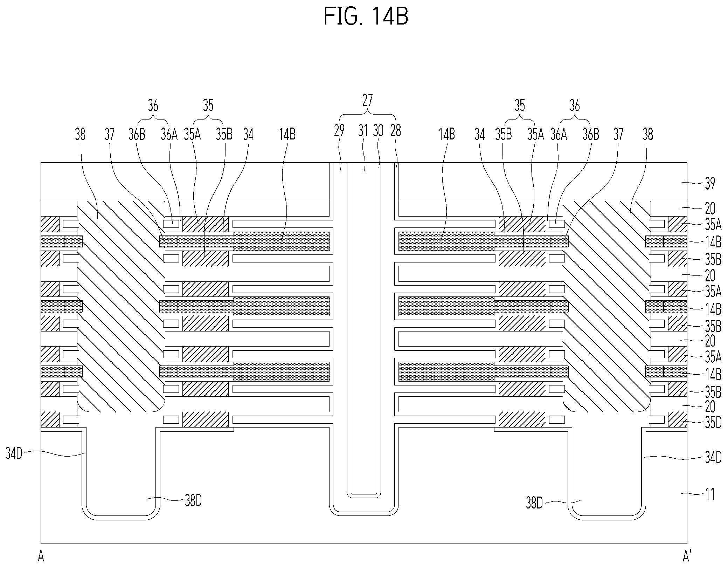

FIG. 14A is a plan view illustrating the structure with vertical conductive lines 38 for describing a method for forming the vertical conductive lines 38, and FIG. 14B is a cross-sectional view illustrating the structure taken along line A-A' illustrated in FIG. 14A.

As illustrated in FIGS. 14A and 14B, a first capping layer 36 may be formed on one side surface of each of the horizontal conductive lines 35. The first capping layer 36 may include silicon oxide, silicon nitride, silicon carbon oxide, an embedded air gap, or a combination thereof. A deposition process and an etch-back process of a capping material may be performed to form the first capping layer 36. While or after the first capping layer 36 is formed, a portion of the inter-level dielectric layer 34 may be removed, and a first edge portion of each of the horizontal layers 14B may be exposed. The first capping layer 36 may include a stack of a first capping liner 36A and a first capping gap-fill layer 36B. The first capping liner 36A may include silicon oxide, and the first capping gap-fill layer 36B may include silicon nitride. A portion of the first capping gap-fill layer 36B may protrude.

Subsequently, the vertical conductive line 38 coupled to the first edge portion of each of the horizontal layers 14B may be formed. The vertical conductive line 38 may fill the first hole-shape vertical opening 32. The vertical conductive line 38 may be coupled in common to the horizontal layers 14B disposed in the first direction D1. The vertical conductive line 38 may include doped polysilicon, titanium nitride, tungsten, or a combination thereof. The vertical conductive line 38 may be referred to as a bit line or a vertical bit line.

Forming the vertical conductive line 38 may include cutting a portion of the inter-level dielectric layer 34 to expose the first edge portion of each of the horizontal layers 14B and performing a deposition and an etch process of a material for the vertical conductive line 38.

Before the vertical conductive line 38 is formed, a first doped region 37 may be formed. The first doped region 37 may be formed in the first edge portion of each of the horizontal layers 14B. Forming the first doped region 37 may include depositing polysilicon that is doped with an N-type impurity, performing a heat treatment, and removing the doped polysilicon. The first doped region 37 may include an impurity diffused from the doped polysilicon. According to another embodiment of the present disclosure, the first doped region 37 may be formed by a process of doping an impurity. The vertical conductive line 38 may include a first contact node (refer to "BLC" of FIGS. 2A and 2B), and the first doped region 37 may include an impurity diffused from the first contact node. A metal silicide layer may be further formed between the vertical conductive line 38 and the first contact node.

Before the vertical conductive line 38 is formed, a second passivation layer 38D may be formed to fill the bottom portion of the first hole-shape vertical opening 32. The second passivation layer 38D, which is a dielectric material, may include silicon oxide, silicon nitride, or a combination thereof. The vertical conductive line 38 and the lower structure 11 may be electrically isolated by the second passivation layer 38D. The second passivation layer 38D may be formed on the first passivation layer 34D. A stack of the first passivation layer 34D and the second passivation layer 38D may include a double stack of silicon oxide/silicon nitride or a triple stack of silicon oxide/silicon nitride/silicon oxide.

According to another embodiment of the present disclosure, after the first capping layer 36 is formed, the second passivation layer 38D may be formed. After the second passivation layer 38D is formed, a process of cutting a portion of the inter-level dielectric layer 34 to expose the first edge portion of each of the horizontal layers 14B and a process of depositing and etching a material for the vertical conductive line 38 may be performed.

The vertical conductive line 38 may correspond to the first conductive line BL as illustrated with reference to FIGS. 1A to 2B.

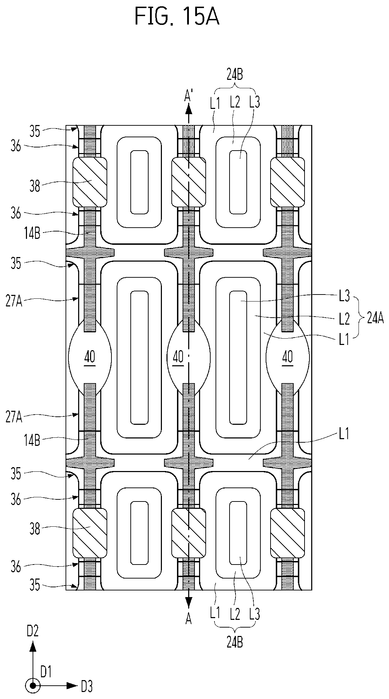

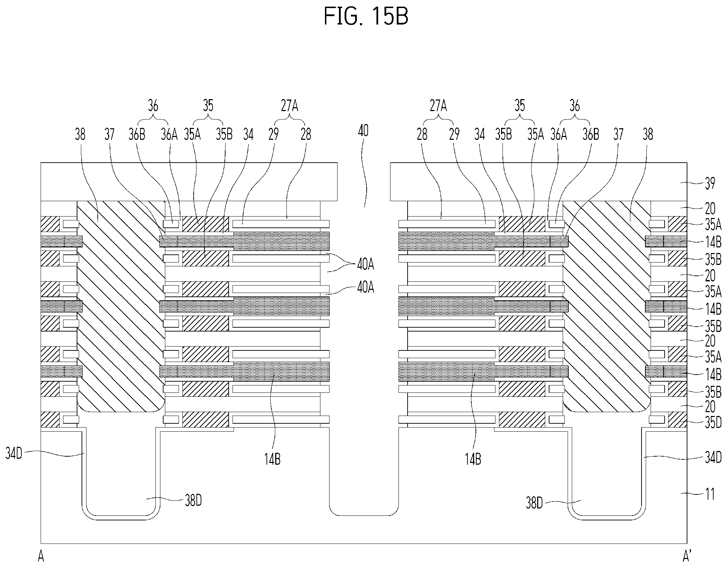

FIG. 15A is a plan view illustrating the structure with second hole-shape vertical openings 40 for describing a method for forming the second hole-shape vertical openings 40, and FIG. 15B is a cross-sectional view illustrating the structure taken along line A-A' illustrated in FIG. 15A.

As illustrated in FIGS. 15A and 15B, a portion of the vertical sacrificial structure 27 may be recessed (refer to reference numeral "40A") to form the second hole-shape vertical openings 40. One side surfaces of the horizontal layers 14B, that is, second edge portions, may be exposed by the second hole-shape vertical openings 40. After the second hole-shape vertical openings 40 are formed, preliminary second capping layers 27A may be formed on the upper and lower surfaces of the horizontal layers 14B. Each of the preliminary second capping layers 27A may include a stack of a second capping liner 28 and a second capping gap-fill layer 29. The second capping liner 28 may include silicon oxide, and the second capping gap-fill layer 29 may include silicon nitride. A portion of the second capping gap-fill layer 29 may protrude. The recess 40A process performed on a portion of the vertical sacrificial structure 27 may be an oxide recess process, and the amount of the recess 40A may be minimized.

The cell isolation liner layers L1 of the first cell isolation layers 24A may be partially etched to form the second hole-shape vertical openings 40. The second hole-shape vertical openings 40 may not contact the stopper layers L2.

From the perspective of a top view, the second hole-shape vertical openings 40 may expose all surfaces of the second edge portions of the horizontal layers 14B.

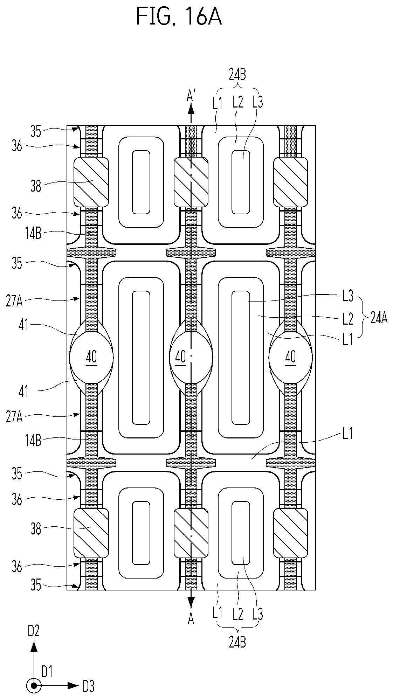

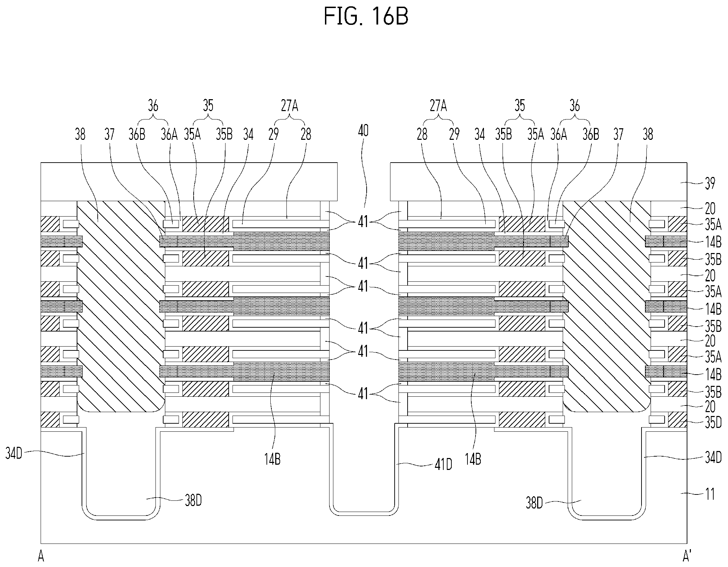

FIG. 16A is a plan view illustrating the structure with first pocket layers 41 for describing a method for forming the first pocket layers 41, and FIG. 16B is a cross-sectional view illustrating the structure taken along line A-A' illustrated in FIG. 16A.

As illustrated in FIGS. 16A and 16B, the first pocket layers 41 may be formed on the sidewalls of the second hole-shape vertical openings 40. Forming the first pocket layers 41 may include depositing a first pocket material and etching back the first pocket material. The first pocket layers 41 may include a material having an etch selectivity with respect to the horizontal layers and the cell isolation layers. The first pocket layers 41 may include silicon nitride, polysilicon, metal, or a combination thereof. The first pocket layers 41 may contact the preliminary second capping layers 27A. In an embodiment, the first pocket layers 41 may contact an edge portion of the top and bottom surfaces of the second capping gap-fill layer 29 but may leave a side edge of the second capping gap-fill layer 29 exposed to the second hole-shape vertical opening 40. In an embodiment, the first pocket layers 41 may also contact a side edge of the second capping liner 28. The first pocket layers 41 and the second capping gap-fill layers 29 of the preliminary second capping layers 27A may be made of the same material. The second edge side surfaces of the horizontal layers 14B may be exposed by a combination of the first pocket layers 41 and the second capping gap-fill layers 29 of the preliminary second capping layers 27A.

While the first pocket layers 41 are formed, a sacrificial passivation layer 41D may be formed on the surface of the lower structure 11. The sacrificial passivation layer 41D may include silicon nitride.

The first pocket layers 41 may cover the second dielectric layers 20.

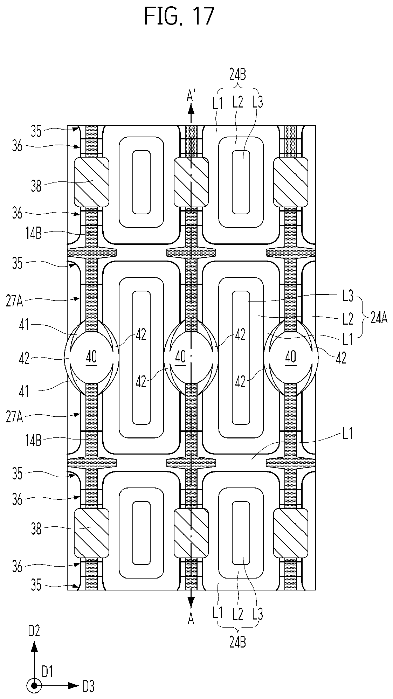

FIG. 17 is a plan view illustrating the structure with pocket openings 42 for describing a method for forming the pocket openings 42.

As illustrated in FIG. 17, the pocket openings 42 may be formed using the first pocket layers 41 as a barrier. To form the pocket openings 42, the cell isolation liners L1 of the first cell isolation layers 24A may be etched using the first pocket layers 41 as a barrier. The etch process for forming the pocket openings 42 may stop at the stopper layers L2 of the first cell isolation layers 24A, and thus the pocket openings 42 may not extend to the cell isolation gap-fill layers L3.

During the etch process for forming the pocket openings 42, the first pocket layers 41 may protect the second dielectric layers 20. Accordingly, the loss of the second dielectric layers 20 may be suppressed.

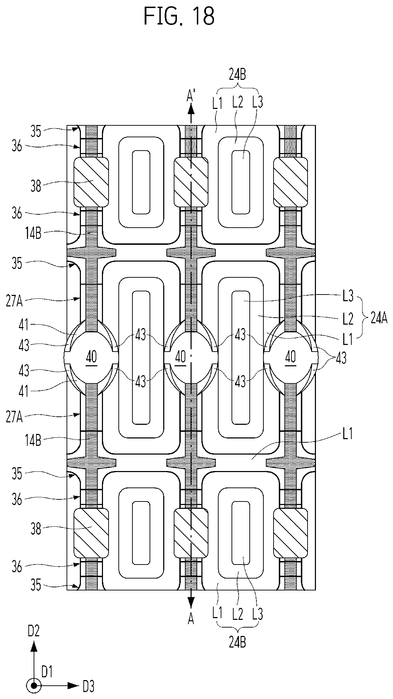

FIG. 18 is a plan view illustrating the structure with second pocket layers 43 for describing a method for forming the second pocket layers 43.

Referring to FIG. 18, the second pocket layers 43 may be formed to fill the pocket openings 42. Forming the second pocket layers 43 may include depositing a second pocket material and etching back the second pocket material. The second pocket layers 43 may include silicon nitride. The second pocket layers 43 may contact the first pocket layers 41. The first pocket layers 41 and the second pocket layers 43 may be the same material. The second pocket layers 43 may include a material having an etch selectivity with respect to the horizontal layers and the cell isolation layers. The second pocket layers 43 may include silicon nitride, polysilicon, metal, or a combination thereof.

The second pocket layers 43 may contact the stopper layers L2 and cell isolation liner layers L1 of the first cell isolation layers 24A. The cell isolation liner layers L1 may be protected by a double structure of the first pocket layers 41 and the second pocket layers 43.

As described above, the double pocket structure of the first pocket layers 41 and the second pocket layers 43 may be formed according to an embodiment of the present disclosure.

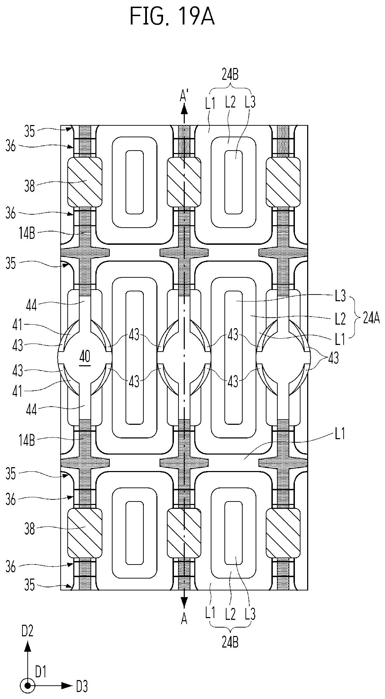

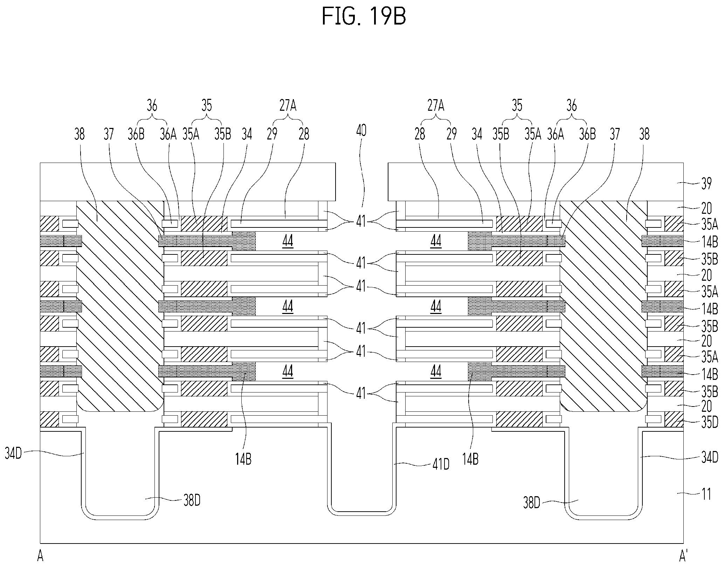

FIG. 19A is a plan view illustrating the structure with initial storage openings 44 for describing a method for forming the initial storage openings 44, and FIG. 19B is a cross-sectional view illustrating the structure taken along line A-A' illustrated in FIG. 19A.

As illustrated in FIGS. 19A and 19B, the second edge portions of the horizontal layers 14B may be horizontally recessed in the second direction D2 to form the initial storage openings 44. The initial storage openings 44 may be formed between the preliminary second capping layers 27A. The initial storage openings 44 may extend from the second hole-shape vertical openings 40.

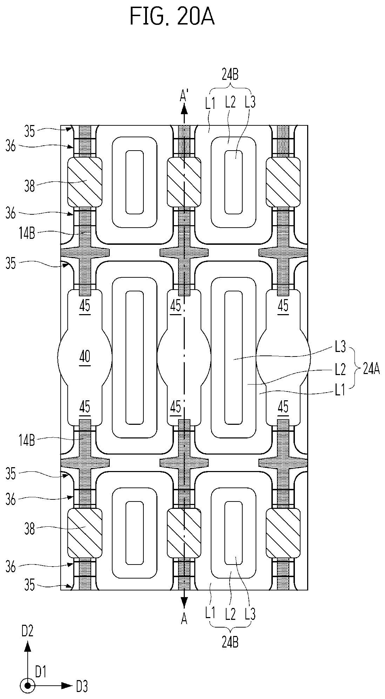

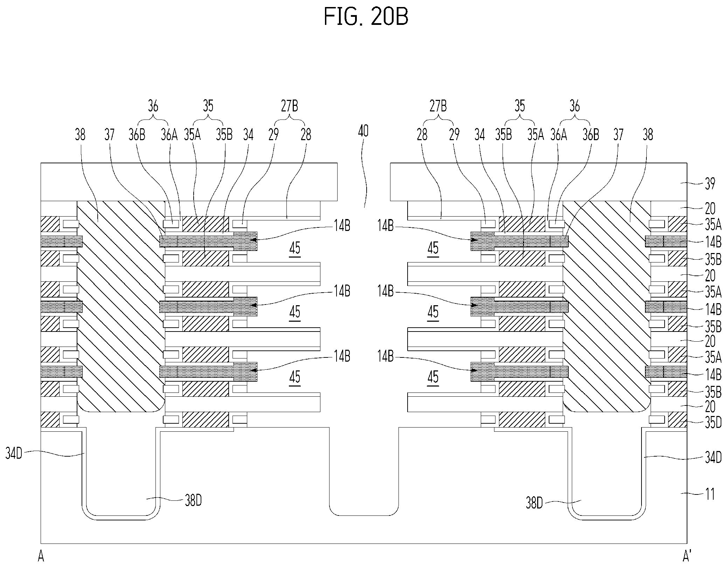

FIG. 20A is a plan view illustrating the structure with storage openings 45 for describing a method for forming the storage openings 45, and FIG. 20B is a cross-sectional view illustrating the structure taken along line A-A' illustrated in FIG. 20A.

As illustrated in FIGS. 20A and 20B, portions of the preliminary second capping layers 27A may be selectively recessed to form second capping layers 27B. The second capping layers 27B may include silicon oxide, silicon nitride, or a combination thereof. Each of the second capping layers 27B may include a stack of a second capping liner 28 and a second capping gap-fill layer 29.

Forming the second capping layers 27B may include recessing the second capping liner 28 and recessing the second capping gap-fill layer 29. During or after the recessing of the second capping gap-fill layer 29, the first and second pocket layers 41 and 43 and the sacrificial passivation layer 41D may be removed.

The initial storage openings 44 may be expanded in volume in a vertical direction and a horizontal direction by such recess processes to form the storage openings 45. The storage openings 45 may be referred to as capacitor openings.

The second edge portions of the horizontal layers 14B may protrude by the storage openings 45.

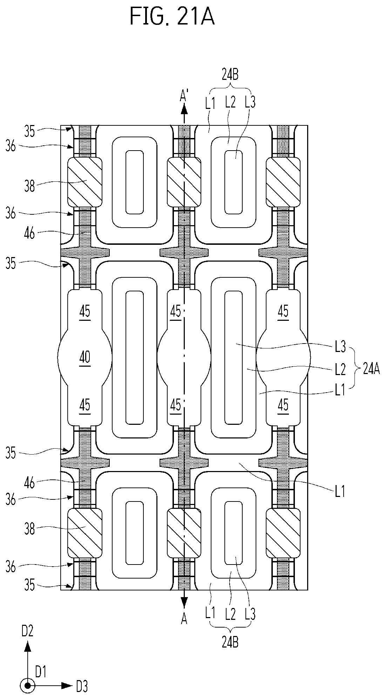

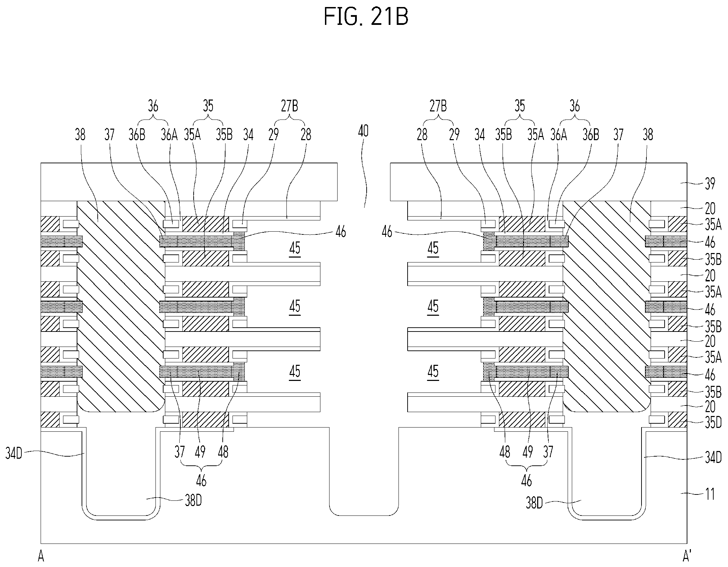

FIG. 21A is a plan view illustrating the structure with horizontal layers 46 for describing a method for forming the horizontal layers 46, and FIG. 21B is a cross-sectional view illustrating the structure taken along line A-A' illustrated in FIG. 21A.

As illustrated in FIGS. 21A and 21B, the second edge portions of the horizontal layers 14B may be horizontally recessed to form the horizontal layers 46. Each of the horizontal layers 46 may include a first edge and a second edge. The first edge may refer to a portion coupled to the vertical conductive lines 38, and the second edge may refer to a portion exposed by the storage openings 45.

The storage openings 45 may be disposed between the second dielectric layers 20. The second capping layers 27B may be disposed on the lower and upper portions of the horizontal layers 46.

Subsequently, second doped regions 48 may be formed in the second edges of the horizontal layers 46. Forming the second doped regions 48 may include depositing polysilicon doped with an N-type impurity, performing a heat treatment, and removing the doped polysilicon. The second doped regions 48 may include impurities diffused from the doped polysilicon. According to another embodiment of the present disclosure, the doped polysilicon may remain after the heat treatment is performed.

Each of the horizontal layers 46 may include the first doped region 37, the second doped region 48, and a channel 49, which are horizontally disposed in the second direction D2. The channel 49 may be defined between the first doped region 37 and the second doped region 48. The channels 49 may vertically overlap with the horizontal conductive lines 35. As described with reference to FIGS. 1A to 1D, the horizontal layers 46 may each have a cross shape, and the channels 49 may each have a cross shape as well.

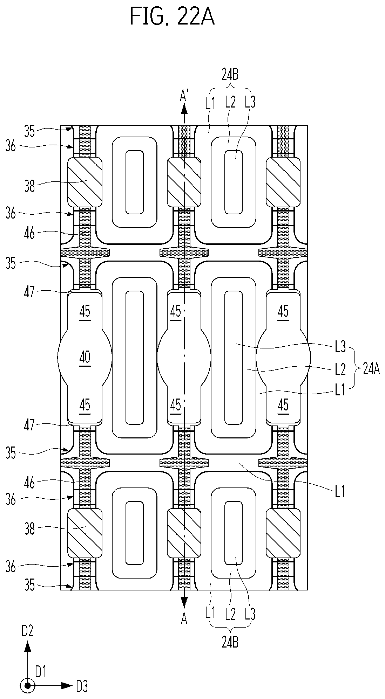

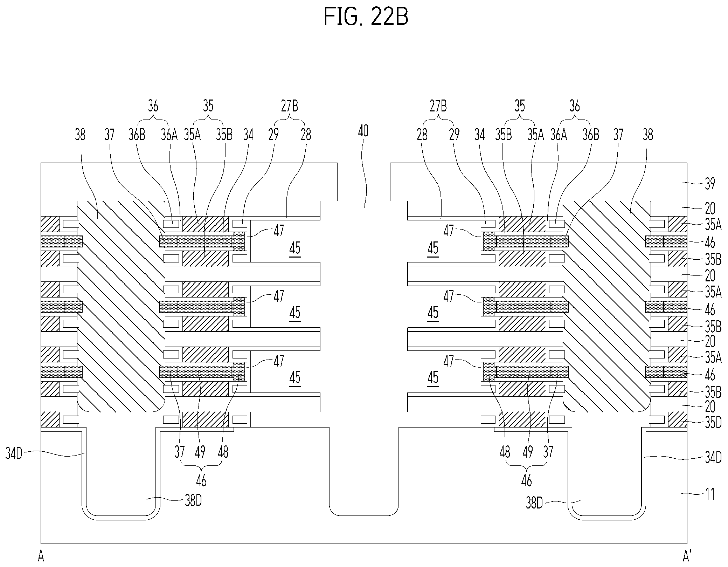

FIG. 22A is a plan view illustrating the structure with second contact nodes 47 for describing a method for forming the second contact nodes 47, and FIG. 22B is a cross-sectional view illustrating the structure taken along line A-A' illustrated in FIG. 22A.

As illustrated in FIGS. 22A and 22B, the second contact nodes 47 may be formed on the second edges of the horizontal layers 46. The second contact nodes 47 may include doped polysilicon. The second contact nodes 47 may be referred to as inner-type contact nodes. The inner-type contact node may refer to a structure disposed in the storage openings 45. The second contact nodes 47 may correspond to the second contact nodes SNC illustrated in FIGS. 1A to 2B. According to another embodiment of the present disclosure, heat treatment may be performed after the second contact nodes 47 are formed to form the second doped regions 48. Accordingly, the second doped regions 48 may include impurities diffused from the second contact nodes 47.

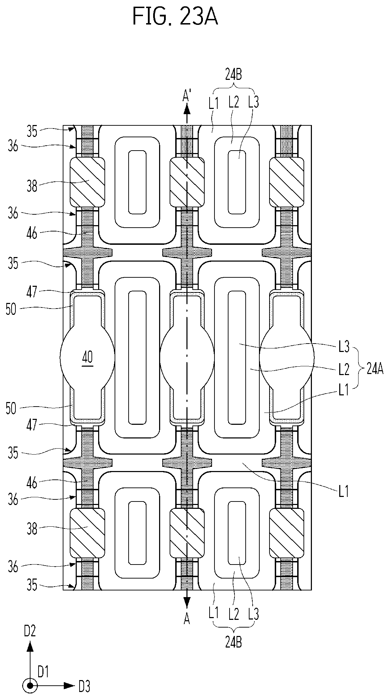

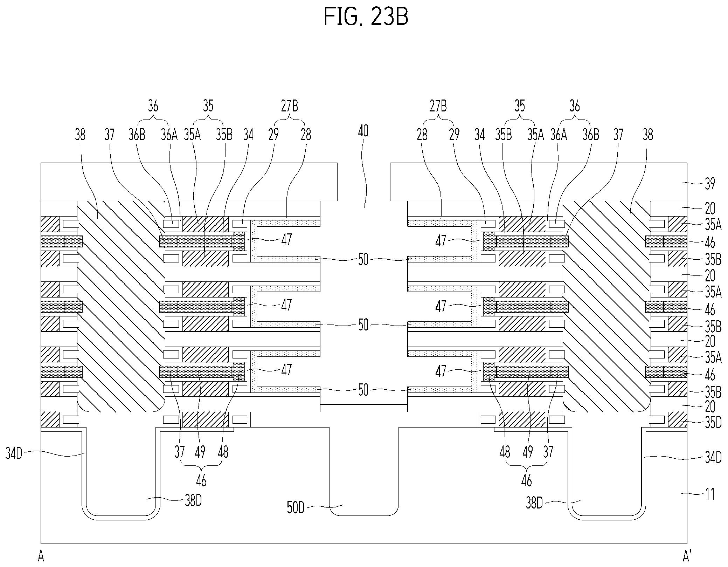

FIG. 23A is a plan view illustrating the structure with first electrodes 50 for describing a method for forming the first electrodes 50, and FIG. 23B is a cross-sectional view illustrating the structure taken along line A-A' illustrated in FIG. 23A.

As illustrated in FIGS. 23A and 23B, the first electrodes 50 of a data storage element may be formed on the second contact nodes 47. The first electrodes 50 may each have a horizontally oriented cylindrical shape. The first electrodes 50 may be disposed in the storage openings 45. The first electrodes 50 disposed adjacent to each other in the second direction D2 may be spaced apart from each other by the second hole-shape vertical openings 40. The first electrodes 50 disposed adjacent to each other in the third direction D3 may be spaced apart from each other by the first cell isolation layers 24A. Before the first electrodes 50 are formed, third passivation layers 50D may be formed to fill the bottom portions of the second hole-shape vertical openings 40. The third passivation layers 50D may include a dielectric material, such as silicon oxide, silicon nitride, or a combination thereof.

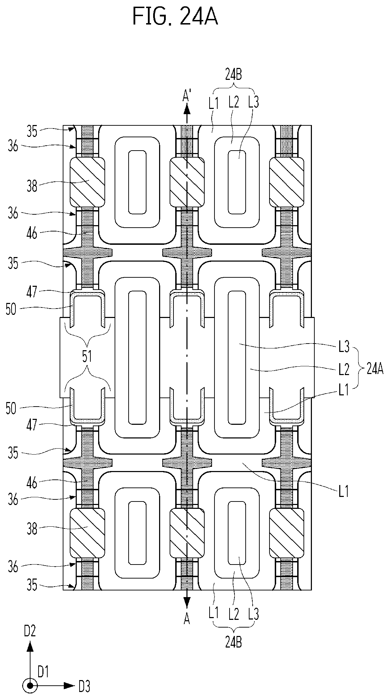

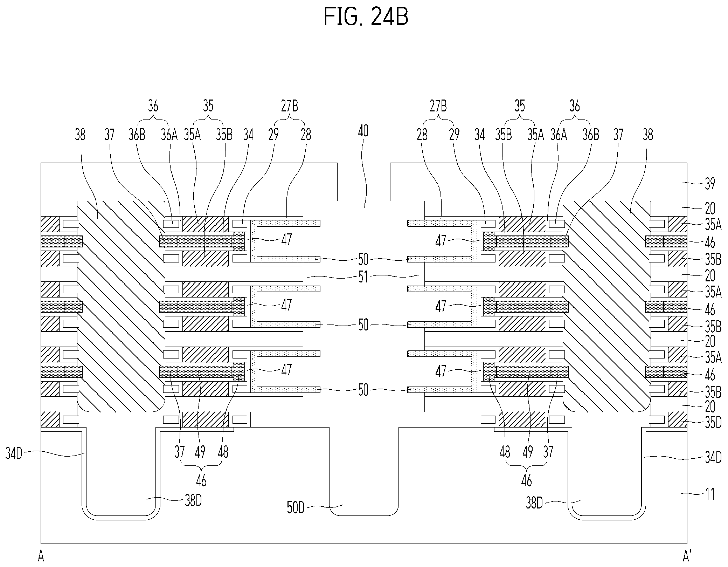

FIG. 24A is a plan view illustrating the structure with the first electrodes 50 for describing a method for exposing the outer walls of the first electrodes 50, and FIG. 24B is a cross-sectional view illustrating the structure taken along line A-A' illustrated in FIG. 24A.

As illustrated in FIGS. 24A and 24B, the second dielectric layers 20 may be horizontally recessed as indicated by reference numeral "51". While the second dielectric layers 20 are recessed, portions of the cell isolation liner layers L1 may be recessed.

By the recess process performed on the second dielectric layers 20 and the cell isolation liner layers L1, the outer walls of the first electrodes 50 which are proximate to the second hole-shape vertical opening 40 may be partially exposed. The first electrodes 50 may each have a semi-cylindrical shape. The recessed second dielectric layers 20 may correspond to the inter-cell dielectric layers IL illustrated with reference to FIG. 2B.

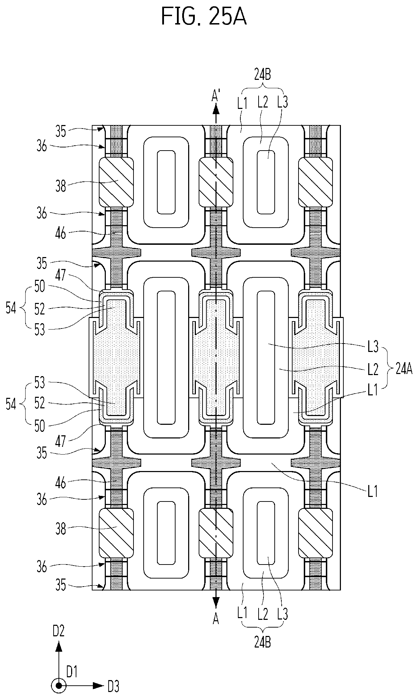

FIG. 25A is a plan view illustrating the structure with a dielectric layer 52 and a second electrode 53 for describing a method for forming the dielectric layer 52 and the second electrode 53, and

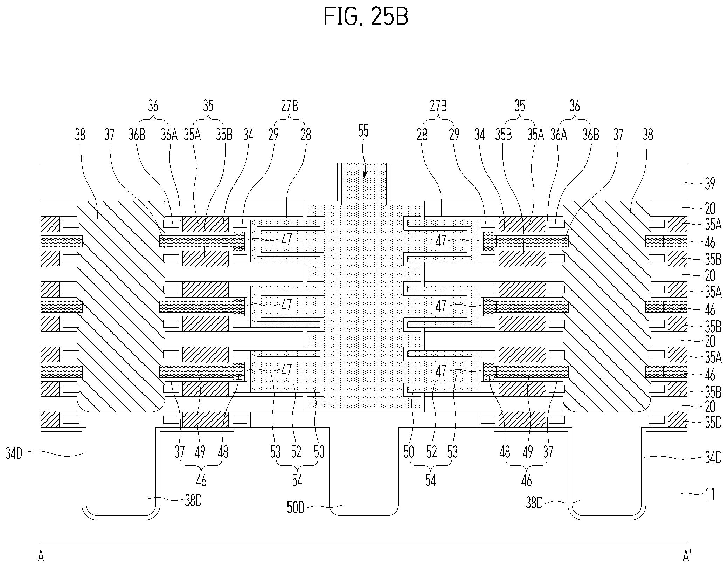

FIG. 25B is a cross-sectional view illustrating the structure taken along line A-A' illustrated in FIG. 25A.

As illustrated in FIGS. 25A and 25B, the dielectric layer 52 and the second electrode 53 may be sequentially formed on the first electrode 50. The first electrode 50, the dielectric layer 52, and the second electrode 53 may be a data storage element 54.

The first electrode 50 may include an inner space and a plurality of outer surfaces, and the inner space of the first electrode 50 may include a plurality of inner surfaces. The outer surfaces of the first electrode 50 may include a vertical outer surface and a plurality of horizontal outer surfaces. The vertical outer surface of the first electrode 50 may vertically extend in the first direction D1, and the horizontal outer surfaces of the first electrode 50 may horizontally extend in the second direction D2 or the third direction D3. The inner space of the first electrode 50 may be a three-dimensional space. The dielectric layer 52 may conformally cover the inner and outer surfaces of the first electrode 50. The second electrode 53 may be disposed in the inner space of the first electrode 50 on the dielectric layer 52. Some of the outer surfaces of the first electrode 50 may be electrically coupled to the second doped region 48 of the horizontal layer 46 and the contact node 47.

The first electrode 50 may have a cylindrical shape. The cylindrical shape of the first electrode 50 may include cylindrical inner surfaces and cylindrical outer surfaces. Some of the cylindrical outer surfaces of the first electrode 50 may be electrically coupled to the second doped region 48 of the horizontal layer 46 and the contact node 47. The dielectric layer 52 and the second electrode 53 may be disposed on the cylindrical inner surfaces of the first electrode 50. The second electrode 53 may vertically extend in the first direction D1. The second electrodes 53 of the data storage elements 54 may be merged with one another to form a common plate 55.

The first electrode 50 and the second electrode 53 may include metal, noble metal, metal nitride, conductive metal oxide, conductive noble metal oxide, metal carbide, metal silicide, or a combination thereof. For example, the first electrode 50 and the second electrode 53 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/ titanium nitride (TiSiN/TiN) stack, a titanium nitride/titanium silicon nitride (TiN/TiSiN) stack, or a combination thereof. The second electrode 53 may include a combination of a metal-based material and a silicon-based material. For example, the second electrode 53 may be a stack (TiN/SiGe/WN) of titanium nitride/silicon germanium/tungsten nitride. In the titanium nitride/silicon germanium/tungsten nitride (TiN/SiGe/WN) stack, silicon germanium may be a gap-fill material that fills the inner space of the first electrode 50, and titanium nitride (TiN) may serve as the second electrode 53 of the data storage element 54, and tungsten nitride may be a low-resistance material.

The dielectric layer 52 may be referred to as a capacitor dielectric layer or a memory layer. The dielectric layer 52 may include silicon oxide, silicon nitride, a high-k material, a ferroelectric material, an anti-ferroelectric material, a perovskite material, or a combination thereof. The dielectric layer 52 may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅) or strontium titanium oxide (SrTiO₃). The dielectric layer 52 may include a ZA (ZrO₂/Al₂O₃) stack, a ZAZ (ZrO₂/Al₂O₃/ZrO₂) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HA (HfO₂/Al₂O₃) stack, a HAH (HfO₂/Al₂O₃/HfO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH(HfO₂/ZrO₂/Al₂O₃/ZrO₂/HfO₂) stack, a ZHZAZHZ(ZrO₂/HfO₂/ZrO₂/Al₂O₃/ZrO₂/HfO₂/ZrO₂) stack, a HZHZ(HfO₂/ZrO₂/HfO₂/ZrO₂) stack, or AHZAZHA(Al₂O₃/HfO₂/ZrO₂/Al₂O₃/ZrO₂/HfO₂/Al₂O₃) stack..

According to another embodiment of the present disclosure, an interface control layer may be further formed between the first electrode 50 and the dielectric layer 52 to reduce leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode 50 and the dielectric layer 52.

According to embodiments of the present disclosure, the loss of the second dielectric layers 20 may be reduced through a dual process of the first pocket layers 41 and the second pocket layers 43. Accordingly, the length of available space in which the data storage element is formed may be secured, which makes it possible to increase capacitance of the data storage element.

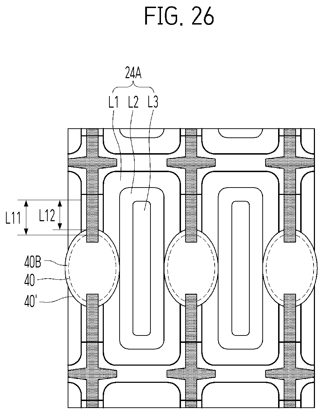

FIG. 26 is a plan view illustrating the structure with second hole-shape vertical openings 40' for describing a method for forming the second hole-shape vertical openings 40'. A comparative example includes a single pocket layer of the first pocket layer, and an embodiment includes a double pocket layer of the first and second pocket layers. In the comparative example and the embodiment, the pocket layer may be formed to prevent loss of the cell isolation layer 24A during a subsequent process.

Referring to FIG. 26, the second hole-shape vertical openings 40 according to the embodiment may be formed smaller than the second hole-shape vertical openings 40' according to the comparative example. That is, the amount of recess 40B for forming the second hole-shape vertical openings 40 may be smaller than the second hole-shape vertical openings 40' according to the comparative example.

As described above, since the amount of recess 40B for forming the second hole-shape vertical openings 40 is small according to the embodiment, a length L11 of available space where the data storage element is to be formed may be secured more greatly. Since the amount of recess for forming the second hole-shape vertical openings 40' is large according to the comparative example, a length L12 of available space where the data storage element is to be formed may be reduced, and accordingly, a decrease in capacitance of the data storage element is inevitable.

According to an embodiment of the present disclosure, it is possible to reduce the loss of the second dielectric layers 20 by approximately 20 nm through the dual process of the pocket layer, using the forming of the first pocket layer 41, the forming of the pocket opening 42, and the forming of the second pocket layer 43, and accordingly, the available space where the data storage element is to be formed may be secured by approximately 20 nm more.

According to an embodiment of the present disclosure, as a double pocket layer is formed, loss of surrounding structures may be suppressed, which makes it possible to increase the available space of the data storage element.

While the embodiments of the present disclosure have been illustrated and described with respect to specific embodiments and drawings, the disclosed embodiments are not intended to be restrictive. Further, it is noted that the present disclosure may be achieved in various ways through substitution, change, and modification of the described embodiments, as those skilled in the art will recognize in light of the present disclosure, without departing from the technical concepts and scope of the present disclosure and the following claims. Furthermore, the embodiments may be combined to form additional embodiments.

### Embodiments:

In some embodiments,
in the method of claim 9, forming the data storage element includes:
removing the double pocket layer;
forming inner-type contact nodes coupled to the recessed horizontal layer patterns in the storage openings;
forming a first electrode on the inner-type contact nodes;
forming a dielectric layer on the first electrode; and
forming a second electrode on the dielectric layer.
In some embodiments,
the method of claim 9 further comprises:
forming horizontal conductive lines that intersect with the horizontal layer patterns; and
forming a vertical conductive line coupled in common to the horizontal layer patterns.

## Claims

1. A method for fabricating a semiconductor device, the method comprising:
forming a vertical stack in which dielectric layers are alternately stacked with horizontal layer patterns, over a lower structure;
forming cell isolation layers that contact side surfaces of the horizontal layer patterns and vertically extend in the vertical stack;
forming a sacrificial structure that covers upper surfaces and lower surfaces of the horizontal layer patterns in the vertical stack;
forming a hole-shape opening that vertically extends, by etching the sacrificial structure and the cell isolation layers;
forming a double pocket layer on a sidewall of the hole-shape opening;
forming storage openings, by recessing the horizontal layer patterns and the cell isolation layers using the double pocket layer as a barrier; and
forming a data storage element in each of the storage openings.

2. The method of claim 1, wherein the forming of the double pocket layer includes:
forming a first pocket layer exposing edge portions of the horizontal layer patterns and the cell isolation layers;
forming a pocket opening by etching the cell isolation layers and using the first pocket layer as a barrier; and
forming a second pocket layer on a sidewall of the pocket opening.

3. The method of claim 2, wherein each of the first and second pocket layers includes a material having an etch selectivity with respect to the horizontal layer patterns and the cell isolation layers.

4. The method of claim 2, wherein the first and second pocket layers include the same material.

5. The method of claim 2, wherein each of the first and second pocket layers includes silicon nitride, polysilicon, metal, or a combination thereof.

6. The method of claim 1, wherein each of the horizontal layer patterns includes monocrystalline silicon, an oxide semiconductor material, or a two-dimensional material.

7. The method of claim 1, wherein the forming of the data storage element includes:
removing the double pocket layer;
forming inner-type contact nodes coupled to the recessed horizontal layer patterns in the storage openings;
forming a first electrode on the inner-type contact nodes;
forming a dielectric layer on the first electrode; and
forming a second electrode on the dielectric layer.

8. The method of claim 1, further comprising:
forming horizontal conductive lines that intersect with the horizontal layer patterns; and
forming a vertical conductive line coupled in common to the horizontal layer patterns.

9. A method for fabricating a semiconductor device, the method comprising:
forming a vertical stack in which dielectric layers are alternately stacked with horizontal layer patterns, over a lower structure;
forming cell isolation layers that contact side surfaces of the horizontal layer patterns and vertically extend in the vertical stack;
forming a sacrificial structure that covers upper surfaces, lower surfaces, and edges of the horizontal layer patterns in the vertical stack;
etching the sacrificial structure and forming a capping layer covering the upper surfaces and lower surfaces of the horizontal layer patterns and a hole-shape opening exposing the dielectric layers, the horizontal layer patterns, and the cell isolation layers;
forming a double pocket layer that covers the dielectric layers and the capping layer and exposes the edges of the horizontal layer patterns;
forming storage openings by recessing the horizontal layer patterns and the cell isolation layers using the double pocket layer as a barrier; and
forming a data storage element in each of the storage openings.

10. The method of claim 9, wherein forming the double pocket layer includes:
forming a first pocket layer exposing edge portions of the horizontal layer patterns and the cell isolation layers;
forming a pocket opening by etching the cell isolation layers using the first pocket layer as a barrier; and
forming a second pocket layer on a sidewall of the pocket opening.

11. The method of claim 10, wherein each of the first and second pocket layers includes a material having an etch selectivity with respect to the horizontal layer patterns and the cell isolation layers.

12. The method of claim 10, wherein the first and second pocket layers include the same material.

13. The method of claim 10, wherein each of the first and second pocket layers includes silicon nitride, polysilicon, metal, or a combination thereof.
